# EUROPÄISCHE PATENTSCHRIFT

(11) **EP 3 856 938 B1**
(45) Veröffentlichungstag und Bekanntmachung des Hinweises auf die Patenterteilung: **22.05.2024**
(21) Anmeldenummer: 19778923.3
(22) Anmeldetag: 23.09.2019
(51) Int. Cl.: C21D 8/12, C22C 38/02, C23C 16/40, C23C 16/453, C23C 16/54, H01F 1/18, C23C 16/511

(54) **VERFAHREN ZUR HERSTELLUNG EINES MIT EINER ISOLATIONSSCHICHT VERSEHENEN KORNORIENTIERTEN ELEKTROBANDES UND KORNORIENTIERTES ELEKTROBAND**
PROCESS FOR PRODUCING A GRAIN-ORIENTED MAGNETIC STEEL STRIP PROVIDED WITH AN INSULATING LAYER AND GRAIN-ORIENTED MAGNETIC STEEL STRIP
PROCÉDÉ POUR FABRIQUER UN FEUILLARD MAGNÉTIQUE À GRAINS ORIENTÉS MUNI D'UNE COUCHE ISOLANTE ET FEUILLARD MAGNÉTIQUE À GRAINS ORIENTÉS

(30) Priorität: 26.09.2018 DE 102018216457; 26.09.2018 DE 102018216453
(43) Veröffentlichungstag der Anmeldung: 04.08.2021
(73) Patentinhaber: ThyssenKrupp Electrical Steel GmbH, 45881 Gelsenkirchen (DE); thyssenkrupp AG, 45143 Essen (DE)
(72) Erfinder: SCHEPERS, Carsten, 46348 Raesfeld (DE); KRATOCHVIL, Jasmina, 45329 Essen (DE); HECHT, Christian, 45481 Mülheim an der Ruhr (DE); LAHN, Ludger, 47447 Moers (DE); WIGGERS, Hartmut, 48734 Reken (DE); SCHULZ, Christof, 50674 Köln (DE); ZEUNER, Vanessa, 47239 Duisburg (DE)
(74) Vertreter: Cohausz & Florack
(86) Internationale Anmeldenummer: PCT/EP2019/075525
(87) Internationale Veröffentlichungsnummer: WO 2020/064632

(56) Entgegenhaltungen:
- EP-A1- 0 565 029
- WO-A1-03/000951
- WO-A1-2018/074462
- WO-A1-2018/116829

## Beschreibung

Die Erfindung betrifft ein Verfahren zur Herstellung eines mit einer Isolationsschicht versehenen kornorientierten Elektrobandes, wobei das Verfahren mindestens die folgenden Arbeitsschritte umfasst:
(A) Bereitstellen eines kornorientierten Elektrobandes,
(B) Aufbringen einer Isolationsschicht auf mindestens eine Seite des kornorientierten Elektrobandes.

Ebenso betrifft die Erfindung ein mit mindestens einer Isolationsschicht versehenes, kornorientiertes Elektroband und eine praxisgerechte Verwendung eines solchen Elektrobands.

Der Kern von Transformatoren besteht aus einem Stapel dünner Bleche aus kornorientiertem Elektroband mit besonderen physikalischen Eigenschaften, insbesondere magnetischen Eigenschaften und elektrischen Isolationseigenschaften. Dazu wird kornorientiertes Elektroband im Allgemeinen nach Abschluss der finalen Rekristallisationsglühung mit einer Isolationsbeschichtung versehen, damit die einzelnen Lamellen des Stapels im Transformator elektrisch isolierend voneinander getrennt sind und unerwünschte Wirbelströme vermieden werden. Eine weitere Funktion der Isolationsschicht ist die Übertragung einer Zugspannung auf das magnetisch aktive Elektroband zur Verminderung der magnetischen Verluste sowie zur Absenkung der Geräuschentwicklung während der Ummagnetisiervorgänge.

Die Isolationsschicht wird laut Stand der Technik auf die nach der Hochglühung mit einer Forsteritschicht versehene Isolationsschicht in flüssiger Form als Dispersion aufgetragen. Die Hauptbestandteile der Dispersion sind kolloides Siliziumoxid, Monoaluminiumphosphat und Chromverbindungen. Nach Auftragen der Dispersion erfolgt ein Einbrennen der Beschichtung zur Ausbildung einer amorphen, glasartigen Schicht mit den oben genannten Funktionen.

Das aus dem Stand der Technik bekannte Verfahren ist dahingehend zu verbessern, dass beispielsweise eine Dispersion zur Aufbringung der Isolationsschicht, die einen sauren pH-Wert aufweist, bei einer nicht perfekt ausgebildeten Forsteritschicht zur Schädigung des Elektrobandes führen kann. Weiter kann die Qualität der Isolationsschicht von Schwankungen bei der Auftragung der Dispersion, beispielsweise durch das Zusammenspiel von Viskosität, Rollendruck bei der Applikation und Oberflächenrauhigkeit der Forsteritschicht, sowie einer natürlichen Verteilung der Partikelgröße in der Dispersion negativ beeinflusst sein. Schließlich ist die Stabilität der Dispersion aufgrund der kolloidalen Komponenten begrenzt und nur durch stabilisierend wirkende Zusätze sicherzustellen, die wiederum Auswirkungen auf die Glasbildung haben.

EP 1 752 549 A1 offenbart ein Verfahren zur Herstellung eines mit einer Isolationsschicht versehenen kornorientierten Elektrobandes, wobei im letzten Verfahrensschritt eine Lösung enthaltend Vorläuferverbindungen zum Erhalt einer Isolationsschicht aufgetragen wird.

In EP 2 252 722 B1 und EP 2 652 172 B1 werden ebenfalls Verfahren offenbart, in denen kornorientierte Elektrobänder mit Isolationsschichten, die gegebenenfalls Chrom enthalten können, versehen werden. Auch bei diesen Verfahren werden entsprechende Vorläuferverbindungen als Lösung aufgebracht.

Neben dem voranstehend erläuterten Stand der Technik ist aus der EP 1 397 527 B1 ein Verfahren zur Herstellung von kornorientiertem Elektroband mit einer elektrisch isolierenden Beschichtung bekannt, bei dem ein blechförmiges Stahlsubstrat bereitgestellt wird, das mit einer isolierenden Beschichtung versehen wird, die als Kohlenstoff-Wasserstoff-Netzwerk ausgebildet ist. Derartige Kohlenstoff-Wasserstoff-Netzwerke werden in der Fachsprache auch als "diamantartiger Kohlenstoff' ("DLC") bezeichnet und lassen sich durch ein PVD- (PVD = Physical Vapor Deposition) oder CVD-(CVD = Chemical Vapor Deposition) Verfahren auf das jeweilige Stahlsubstrat auftragen. Praktische Erfahrungen haben ergeben, dass die gemäß diesem Stand der Technik erzeugten Isolationsschichten die in der Praxis an Isolationsschichten für kornorientierte Elektrobänder gestellten Anforderungen nicht erfüllen.

Beispiele für Stand der Technik, bei dem mittels CVD- oder PVD-Verfahren oxidische, nicht-oxidische oder keramische Schichten auf ein kornorientiertes Elektroband aufgebracht werden, sind in der EP 0 565 029 A1, WO 2018/074462 A1 und WO 2018/116829 A1 beschrieben. Gemeinsam ist dem in diesen Dokumenten beschriebenen Stand der Technik, dass, unabhängig von der Art des mittels CVD oder PVD aufzutragenden Überzugs, eine auf dem Stahlsubstrat des jeweiligen Elektrobands vorhandene Forsteritschicht entfernt wird, so dass die jeweilige Beschichtung jeweils auf die blanke Oberfläche des kornorientierten Elektroblechs aufgetragen wird.

Vor dem Hintergrund des voranstehend erläuterten Standes der Technik hat sich die Aufgabe ergeben, ein Verfahren zum Aufbringen einer Isolationsschicht auf einem mit einer Forsteritschicht belegten kornorientierten Elektroband bereitzustellen, welches die aus dem Stand der Technik bekannten Nachteile nicht aufweist.

Die mit dem von der Erfindung bereitzustellenden Verfahren auf einem kornorientierten Elektroband erzeugten Isolationsschichten sollen dabei eine optimierte Isolationswirkung besitzen und hohe Zugspannungen auf das Elektroband übertragen können.

In Bezug auf das Verfahren hat die Erfindung diese Aufgabe dadurch gelöst, dass bei der Erzeugung von kornorientierten Elektrobändern mindestens die in Anspruch 1 angegebenen Arbeitsschritte durchlaufen werden.

Bei kornorientierten Elektrobändern, die durch Anwendung eines erfindungsgemäßen Verfahrens mit einer Isolationsschicht belegt worden sind, sind die Isolationsschichten weitestgehend porenfrei und damit optimal dicht, so dass sie eine maximale Isolationswirkung besitzen.

Ein erfindungsgemäßes kornorientiertes Elektroband zeichnet sich dabei dadurch aus, dass seine Isolationsschicht frei von einem Kohlenstoff-Wasserstoff-Netzwerk ist. Dabei lassen sich erfindungsgemäße kornorientierte Elektrobänder zuverlässig durch Anwendung eines erfindungsgemäßen Verfahrens erzeugen.

Vorteilhafte Ausgestaltungen der Erfindung sind in den abhängigen Ansprüchen angegeben und werden nachfolgend wie der allgemeine Erfindungsgedanke im Einzelnen erläutert.

Das erfindungsgemäße Verfahren zur Herstellung eines mit einer Isolationsschicht versehenen kornorientierten Elektrobandes umfasst demnach in Übereinstimmung mit dem eingangs erläuterten Stand der Technik mindestens die folgenden Schritte:
(A) Bereitstellen eines kornorientierten Elektrobandes,
(B) Aufbringen einer Isolationsschicht auf mindestens eine Seite des kornorientierten Elektrobandes,

Erfindungsgemäß erfolgt nun das Aufbringen der Isolationsschicht in Form eines Filmes oder in Form von Partikeln auf dem kornorientierten Elektroband durch ein Bottom-Up-Verfahren, wobei bei diesem Bottom-Up-Verfahren erfindungsgemäß mindestens eine entsprechende Vorläuferverbindung aus dem Abgas eines Flammenreaktors oder eines Mikrowellenplasmareaktors auf das kornorientierte Elektroband derart aufgebracht wird, dass die Ausbildung eines Kohlenwasserstoffnetzwerkes auf dem kornorientierten Elektroband vermieden wird.

Entscheidend für die Erfindung ist also, dass einerseits der Auftrag der Beschichtung mittels eines geeigneten Bottom-Up-Verfahrens durchgeführt wird, wobei dieses Verfahren dann so betrieben wird, dass auf dem kornorientierten Elektroband kein Kohlenwasserstoffnetzwerk entsteht. Diese Maßgabe beruht auf der Erkenntnis, dass sich auf dem kornorientierten Elektroband abgeschiedener Kohlenstoff, ähnlich wie Poren, negativ auf die Isolationsschicht auswirkt. Indem der an der Oberfläche des kornorientierten Elektroblechs vorhandene Kohlenstoff auf einem minimalen Level gehalten und erforderlichenfalls durch zusätzliche Maßnahmen reduziert wird, gewährleistet die Erfindung die Ausprägung einer optimal gleichmäßigen Isolationsschicht unter Vermeidung des Einsatzes von Dispersionen der im Stand der Technik üblichen Art.

Die einzelnen Verfahrensschritte eines erfindungsgemäßen Verfahrens werden im Folgenden detailliert beschrieben:
Schritt (A) des erfindungsgemäßen Verfahrens umfasst das Bereitstellen eines kornorientierten Elektrobandes.

Im Rahmen der vorliegenden Erfindung kann im Allgemeinen jedes dem Fachmann bekannte kornorientierte Elektroband eingesetzt werden. Die Herstellung eines geeigneten kornorientierten Elektrobandes wird beispielsweise in der EP 1 752 549 A1 beschrieben.

Schritt (A) des erfindungsgemäßen Verfahrens umfasst daher bevorzugt die folgenden Schritte:
(A1) Erschmelzen eines Stahls, der neben Eisen und unvermeidbaren Verunreinigungen (jeweils in Gew.-%) 2,5 bis 4,0 Si, 0,02 bis 0,10 C, 0,01 bis 0,065 Al, 0,003 bis 0,015 N, und wahlweise bis zu 0,30 Mn, bis zu 0,05 Ti, bis zu 0,3 P, eines oder mehrere Elemente aus der Gruppe S, Se in Gehalten, deren Summe höchstens 0,04 beträgt, eines oder mehrere Elemente aus der Gruppe As, Sn, Sb, Te, Bi mit Gehalten von jeweils bis zu 0,2, eines oder mehrere Elemente aus der Gruppe Cu, Ni, Cr, Co, Mo mit Gehalten von jeweils bis zu 0, 5, eines oder mehrere Elemente aus der Gruppe B, V, Nb mit Gehalten von jeweils bis zu 0,012, enthält,
(A2) sekundärmetallurgisches Behandeln der Schmelze aus Schritt (A1) in einem Pfannenofen und/oder einer Vakuumanlage,
(A3) kontinuierliches Abgießen der Schmelze zu einem Strang,
(A4) Zerteilen des Strangs in Dünnbrammen,
(A5) Aufheizen der Dünnbrammen in einem in Linie stehenden Ofen auf eine Temperatur zwischen 1050 °C und 1300 °C,
(A6) kontinuierliches Warmwalzen der Dünnbrammen in einer in Linie stehenden mehrgerüstigen Warmwalzstraße zu einem Warmband mit einer Dicke von 0,5 - 4,0 mm,
(A7) Haspeln des Warmbands zu einem Coil,
(A8) wahlweise: Glühen des Warmbands nach dem Haspeln bzw. vor dem Kaltwalzen,
(A9) Kaltwalzen des Warmbandes zu einem Kaltband mit einer Enddicke von 0,15 mm bis 0,50 mm,
(A10) rekristallisierendes und entkohlendes Glühen des Kaltbands, optional auch mit einem Nitrieren während oder nach der Entkohlung sowie Auftragung einer Aufschlämmung aus im Wesentlichen MgO als Klebschutz,
(A11) Schlussglühen des rekristallisierend und entkohlend geglühten Kaltbands zur Ausprägung einer Gosstextur sowie Umwandlung des MgOs und der Bandoberfläche zu einem Film aus Forsterit (Mg₂SiO₄)

Diese bevorzugte Arbeitsfolge ist so abgestimmt, dass unter Verwendung von konventionellen Aggregaten ein Elektroband erzeugt werden kann, das optimierte elektromagnetische Eigenschaften besitzt.

In Schritt (A1) wird eine Stahlschmelze mit an sich bekannter Zusammensetzung erschmolzen. Diese Schmelze wird dann in Schritt (A2) sekundärmetallurgisch behandelt. Diese Behandlung findet zunächst bevorzugt in einer Vakuumanlage statt, um die chemische Zusammensetzung des Stahls in den gefordert engen Analysenspannen einzustellen und niedrige Wasserstoffgehalte von maximal 10 ppm zu erreichen, um das Risiko des Auftretens von Strangdurchbrüchen beim Vergießen der Stahlschmelze auf ein Minimum zu reduzieren. Im Anschluss an die Behandlung in der Vakuumanlage ist ein Einsatz in einem Pfannenofen zweckmäßig, um im Fall von Angießverzögerungen die für das Gießen erforderliche Temperatur sicherstellen zu können und um durch dortige Schlacken-Konditionierung das Zusetzen der Tauchrohrausgüsse in der Kokille beim Dünnbrammen-Stranggießen und damit einen Gießabbruch zu vermeiden. Erfindungsgemäß wäre auch zunächst der Einsatz eines Pfannenofens zur Schlackenkonditionierung, gefolgt von der Behandlung in einer Vakuumanlage zur Einstellung der chemischen Zusammensetzung der Stahlschmelze in engen Analysengrenzen. Es ist auch möglich, nur den Pfannenofen einzusetzen. Erfindungsgemäß möglich ist weiterhin, nur die Vakuumanlage einzusetzen.

Aus der so behandelten Schmelze wird anschließend in Schritt (A3) ein Strang gegossen, der bevorzugt eine Dicke von 25 mm bis 150 mm aufweist. Die Entstehung eines im Hinblick auf die elektromagnetischen Eigenschaften günstigen Gefüges des gegossenen Stahlstrangs kann auch dadurch unterstützt werden, dass mit niedriger Überhitzungstemperatur gegossen wird. Letztere liegen vorzugsweise maximal 25 K über der Liquidustemperatur der vergossenen Schmelze.

Bei der Herstellung des kornorientierten Elektrobandes wird angestrebt, die Bildung von nitridischen Ausscheidungen vor dem Warmwalzen und während des Warmwalzens möglichst zu vermeiden, um die Möglichkeit einer kontrollierten Erzeugung solcher Ausscheidungen bei der Abkühlung des Warmbandes in großem Umfang nutzen zu können. Um dies zu unterstützen, ist es möglich, eine Inline-Dickenreduzierung des aus der Schmelze gegossenen, jedoch noch kernflüssigen Strangs vorzunehmen. Als an sich bekannte Verfahren zur Dickenreduzierung bieten sich die so genannte "Liquid Core Reduction" - nachfolgend "LCR" - und die so genannte "Soft Reduction" - nachfolgend "SR" - an. Diese Möglichkeiten der Dickenreduktion eines gegossenen Strangs können alleine oder in Kombination eingesetzt werden. Bei der LCR wird die Strangdicke bei kernflüssigem Inneren des Strangs dicht unter der Kokille reduziert. LCR wird beim Stand der Technik in Dünnbrammen-Stranggießanlagen in erster Linie eingesetzt, um geringere Warmband-Enddicken insbesondere bei höherfesten Stählen zu erreichen.

Daneben können durch LCR die Stichabnahmen bzw. die Walzkräfte in den Walzgerüsten der Warmbandstraße mit dem Erfolg gemindert werden, dass der Arbeitswalzenverschleiß der Walzgerüste und die Zunderporigkeit des Warmbands vermindert und der Bandlauf verbessert werden kann. Die durch LCR erzielte Dickenreduktion liegt bevorzugt im Bereich von 5 mm bis 30 mm. Unter SR wird die gezielte Dickenreduktion des Stranges in der Sumpfspitze nahe der Enderstarrung verstanden. Die SR hat zum Ziel, Mittenseigerungen und Kernporosität zu verringern.

Bei bekannten Dünnbrammen-Stranggießanlagen wird der aus der Gießkokille üblicherweise vertikal austretende Strang an tiefer gelegenen Stellen gebogen und in eine horizontale Richtung geführt. Indem gemäß einer weiteren vorteilhaften Ausgestaltung der aus der Schmelze gegossene Strang bei einer 700 °C bis 1000 °C, vorzugsweise bei 850 bis 950 °C, betragenden Temperatur gebogen und gerichtet wird, können Risse an der Oberfläche der von dem Strang abgetrennten Dünnbrammen vermieden werden, zu denen es andernfalls insbesondere in Folge von Kantenrissen des Strangs kommen kann. Im genannten Temperaturbereich weist der verwendete Stahl eine gute Duktilität an der Strangoberfläche bzw. im Kantenbereich auf, so dass er den beim Biegen und Richten auftretenden Verformungen gut folgen kann.

Von dem gegossenen Strang werden in Schritt (A4) in an sich bekannter Weise Dünnbrammen abgeteilt, die anschließend in einem Ofen auf die geeignete Warmwalzanfangstemperatur erwärmt werden und dann dem Warmwalzen zugeführt werden. Die Temperatur, mit der die Dünnbrammen in den Ofen einlaufen, liegt bevorzugt oberhalb von 650 °C. Die Verweilzeit im Ofen sollte unter 60 min betragen, um Klebzunder zu vermeiden.

Für die Erzeugung von kornorientiertem Elektroband kann das Warmwalzen im Anschluss an den ersten Umformstich im Zweiphasengebiet durchgeführt wird. Dazu wird bevorzugt bei Temperaturen warmgewalzt, bei denen im Gefüge des Warmbands austenitische und ferritische Anteile gemischt vorliegen.

Typische Temperaturen, bei denen dies für die erfindungsgemäß verwendeten Stahllegierungen gegeben ist, liegen über rund 800 °C, insbesondere im Bereich von 850 °C bis 1150 °C.

Im Warmwalzvorgang kann im ersten Umformstich ein Umformgrad von bevorzugt mindestens 40% erzeugt werden, um nur relativ geringe Stichabnahmen in den letzten Gerüsten für die Erzielung der gewünschten Endbanddicke nötig zu haben. In dieser Hinsicht bevorzugt liegt daher der über die ersten beiden Umformstiche in der Fertigstraße erzielte Gesamtumformgrad über 60 %, wobei in weiterer vorteilhafter Ausgestaltung der Erfindung im ersten Gerüst der Fertigstraße ein Umformgrad von mehr als 40 % erzielt wird und im zweiten Gerüst der Fertigstraße die Stichabnahme mehr als 30 % beträgt.

Zur Vermeidung eines groben ungleichmäßigen Gefüges bzw. grober Ausscheidungen am Warmband, die sich ungünstig auf die magnetischen Eigenschaften des Endprodukts auswirken würden, ist eine früh einsetzende Abkühlung des Warmbands hinter dem letzten Walzgerüst der Fertigstraße vorteilhaft. Gemäß einer praxisgerechten Ausgestaltung ist es daher vorgesehen, innerhalb von maximal fünf Sekunden nach Verlassen des letzten Walzgerüstes mit der Wasserkühlung zu beginnen. Angestrebt werden dabei möglichst kurze Pausenzeiten, beispielsweise von einer Sekunde und weniger. Die Abkühlung des Warmbands kann auch so gesteuert werden, dass zweistufig mit Wasser gekühlt wird.

Die Haspel-Temperatur in Schritt (A7) sollte bevorzugt im Temperaturbereich von 500 bis 780 °C liegen. Darüber liegende Temperaturen würden einerseits zu unerwünscht groben Ausscheidungen führen und andererseits die Beizbarkeit verschlechtern. Für die Einstellung höherer Haspeltemperaturen (> 700 °C) wird ein so genannter Kurzdistanzhaspel eingesetzt, der direkt im Anschluss an die Kompaktkühlzone angeordnet ist.

Das hier dargestellte Verfahren bei der Herstellung des Warmbandes bevorzugt so durchgeführt, dass das erhaltene Warmband sulfidische und/oder nitridische Ausscheidungen mit einem mittleren Teilchendurchmesser unter 150 nm und einer mittleren Dichte von mindestens 0,05 µm⁻² erreicht wird. Derart beschaffenes Warmband weist optimale Voraussetzungen für die effektive Steuerung des Kornwachstums während der nachfolgenden Prozessschritte auf.

Zur weiteren Optimierung des Gefüges kann das so erzeugte Warmband optional noch nach dem Haspeln bzw. vor dem Kaltwalzen geglüht werden (Schritt (A8)).

Nach dem Kaltwalzen wird das erhaltene Band rekristallisierend und entkohlend geglüht (Teilschritt A10). Das Ziel dieser entkohlenden Glühung ist, die an der Oberfläche des kornorientierten Elektroblechs vorhandenen Kohlenstoffpartikel zu reduzieren. Zur Bildung weiterer Nitrid-Ausscheidungen, die zur Steuerung des Kornwachstums verwendet werden, kann das kaltgewalzte Band während oder nach dem Entkohlungsglühen in einer NH₃-haltigen Atmosphäre aufstickend geglüht werden. Eine weitere Möglichkeit zur Bildung der Nitrid-Ausscheidungen ist die Aufbringung von N-haltigen Klebschutzzusätzen wie beispielsweise Mangannitrid oder Chromnitrid auf das Kaltband im Anschluss an die Entkohlungsglühung mit der Eindiffusion des Stickstoffs in das Band während der Aufheizphase der Schlussglühung bis zur Sekundärrekristallisation.

Der Klebschutz besteht im Wesentlichen aus im Aufschlämmverfahren aufgetragenen MgO, welches mit der Oberfläche des Bandes im Schritt des Schlussglühens (A11) zu einer Forsteritschicht aus Mg₂SiO₄ reagiert. Das Schlussglühen erfolgt gewöhnlich bei einer Spitzentemperatur von 950 bis 1250 °C und dient dem Ausbilden einer Goss-Textur. Die Forsteritschicht kann je nach Glühbedingung, Atmosphäre, Temperatur und Beschaffenheit der Oberfläche sehr kompakt bis porös ausgebildet sein. Diese Ausbildung ist schwer zu kontrollieren, aber beispielsweise durch die Betrachtung eines metallografischen Querschliffs im Licht- oder Elektronenmikroskop nachweisbar.

Nach Schritt (A) des erfindungsgemäßen Verfahrens wird ein kornorientiertes Elektroband erhalten, welches bevorzugt an der Oberfläche eine Forsterit-Schicht aufweist. Dieses kornorientierte Elektroband kann erfindungsgemäß bevorzugt direkt in Schritt (B) des erfindungsgemäßen Verfahrens eingesetzt werden.

Schritt (B) des erfindungsgemäßen Verfahrens umfasst das Aufbringen einer Isolationsschicht auf mindestens eine Seite des kornorientierten Elektrobandes, wobei das Aufbringen der Isolationsschicht in Form eines Filmes oder in Form von Partikeln auf dem kornorientierten Elektroband durch ein Bottom-Up-Verfahren erfolgt, das so betrieben wird, dass kein Kohlenwasserstoff-Netzwerk auf der Oberfläche des kornorientierten Elektrobands entsteht.

Erfindungswesentlich ist, dass das Aufbringen der Isolationsschicht in Form eines Filmes oder in Form von Partikeln auf dem kornorientierten Elektroband durch ein Bottom-Up-Verfahren erfolgt, wobei für das Bottom-Up-Verfahren erfindungsgemäß ein Flammenreaktor, insbesondere ein Sprayflammenreaktor, oder ein Mikrowellenplasmareaktor verwendet wird. Bottom-Up-Verfahren, bei denen mittels eines Flammenreaktors oder eines Mikrowellenplasmareaktors Beschichtungen aufgebracht werden, sind dem Fachmann an sich bekannt. Für die Durchführung des erfindungsgemäßen Verfahrens ist es notwendig, bei der Erzeugung der Isolationsschicht auf dem kornorientierten Elektroblech mindestens eine entsprechende Vorläuferverbindung aus dem Abgas eines Flammenreaktors oder eines Mikrowellenplasmareaktors auf das kornorientierte Elektroband aufzubringen. Die Ausgestaltung und Funktionsweise eines Flammreaktors ist dem Fachmann an sich bekannt und beispielsweise beschrieben in L. Mädler, Journal of Aerosol Science, Volume 33 Issue 2, 2002.

Im Fall, dass für die Erzeugung der Isolationsschicht ein Flammreaktor eingesetzt wird, kann dieser so betrieben werden, dass entweder eine durch Partikel oder eine durch einen Film gebildete Isolationsschicht entsteht. Soll eine filmartige Isolationsschicht entstehen, so kann hierzu im Flammenreaktor ein Druck unterhalb von Atmosphärendruck, beispielsweise 100 bis 1000 mbar (a), bevorzugt 300 bis 850 mbar (a), eingestellt werden. Soll dagegen eine aus Partikeln gebildete Isolationsschicht erzeugt werden, kann bei Einsatz eines Flammenreaktors erreicht werden, dass im Flammenreaktor ein Druck eingestellt wird, der gleich dem Atmosphärendruck ist. Die Temperatur im Inneren des Flammenreaktors beträgt jeweils beispielsweise 200 °C bis 700 °C.

In Schritt (B) des erfindungsgemäßen Verfahrens mindestens eine Vorläuferverbindung, die die gewünschte Isolationsschicht ausbilden kann, eingebracht. Erfindungsgemäß bevorzugt können eine, zwei, drei, vier oder mehr Vorläuferverbindungen eingebracht werden.

Im Fall des Einsatzes eines Flammenreaktors wird in der Flammenreaktor erfindungsgemäß mindestens eine Vorläuferverbindung, die die gewünschte Isolationsschicht ausbilden kann, eingebracht. Erfindungsgemäß bevorzugt können in den Flammenreaktor eine, zwei, drei, vier oder mehr Vorläuferverbindungen eingebracht werden. Erfindungsgemäß bevorzugt ist die in Schritt (B) eingesetzte mindestens eine Vorläuferverbindung ausgewählt aus der Gruppe bestehend aus Si-enthaltenden Verbindungen, beispielsweise Tetraethylorthosilicat (C₈H₂₀O₄Si), Hexamethyldisiloxan (C₅H₁₈OSi₂), Trimethylsilanol (C₃H₁₀OSi), Silane wie Monosilan (SiH₄), Disilan (Si₂H₆) usw., Siloxane wie beispielsweise Hexamethylcyclotrisiloxan ("D3" C₆H₁₈O₃S₁₃), Octamethylcyclotetrasiloxan ("D4" C₈H₂₄O₄Si₄) usw. oder Mischungen davon, P-enthaltenden Verbindungen, beispielsweise Tributylphosphat (C₁₂H₂₇O₄P), Tributylphosphin (C₁₂H₂₇P) oder Mischungen davon, Ti-enthaltenden Verbindungen, beispielsweise Tetraisopropyltitanat (C₁₂H₂₈O₄Ti), Titan(IV)-chlorid (TiCl₄), Titanacetylacetonat (C₁₀H₁₆O₅Ti) oder Mischungen davon, Al-enthaltenden Verbindungen, beispielsweise Aluminiumnitrat Al(NO₃)₃ * 9 H₂0, Aluminiumdiacetat (C₄H₇AlO₅), Aluminium(III)-acetylacetonat (C₁₅H₂₁AlO₆) oder Mischungen davon, Erdalkalimetall-enthaltenden Verbindungen, beispielsweise NaOH, NaNO₃, NaHCO₃, C₂H₃NaO₂, C₅H₇NaO₂ oder Mischungen davon, und Mischungen der genannten Vorläuferverbindungen.

Bei Verwendung eines Flammenreaktors kann die mindestens eine Vorläuferverbindung in Substanz oder in Lösung eingesetzt werden. In einer bevorzugten Ausführungsform des erfindungsgemäßen Verfahrens wird die mindestens eine Vorläuferverbindung in mindestens einem organischen Lösungsmittel gelöst eingesetzt. Erfindungsgemäß sind im Allgemeinen alle organischen Lösungsmittel geeignet, die, abgesehen von CO₂ und H₂O, rückstandsfrei verbrannt werden können. Auf diese Weise wird die Ausbildung eines Kohlenstoff-Wasserstoff-Netzwerks auf der Oberfläche des kornorientierten Elektroblechs sicher vermieden. Hierzu wird das Verbrennungsluftverhältnis λ, das das Massenverhältnis zwischen der im Flammenreaktor tatsächlich zur Verfügung stehenden Luftmasse und der mindestnotwendigen Luftmasse, die für eine stöchiometrisch vollständige Verbrennung theoretisch benötigt wird, angibt, erfindungsgemäß so eingestellt, dass gilt λ ≥ 1. Vorzugsweise wird das Verbrennungsluftverhältnis auf λ >1, insbesondere 1,00 < λ < 1,20, eingestellt, um durch eine Verbrennung unter leichtem Luftüberschuss eine vollständige Umsetzung aller vorhandenen Reaktanten sowie eine vollständige Verbrennung aller Nebenprodukte sicher zu gewährleisten (s. auch Hans Dieter Baehr: Thermodynamik. Springer-Verlag, Berlin/Heidelberg 1988, ISBN 3-540-18073-7).

Erfindungsgemäß ist bei Einsatz eines Flammenreaktors die mindestens eine Vorläuferverbindung in mindestens einem organischen Lösungsmittel, bevorzugt ausgewählt aus der Gruppe bestehend aus Alkoholen, beispielsweise Ethanol, Isopropanol, Methanol, Butanol, 1-Hexanol, aromatischen Kohlenwasserstoffen, beispielsweise Toluol, Xylol, Ethylbenzol Carbonsäuren, beispielsweise Essigsäure, Acrylsäure, und Mischungen davon, gelöst.

Die Konzentration der mindestens einen Vorläuferverbindung in dem mindestens einen Lösungsmittel beträgt dabei bevorzugt 0,10 pro Liter bis 0,50 mol pro Liter, insbesondere 0,125 mol pro Liter bis 0,35 mol pro Liter.

In dem erfindungsgemäß eingesetzten Flammenreaktor wird die mindestens eine Vorläuferverbindung, bevorzugt in mindestens einem organischen Lösungsmittel gelöst, zunächst verdampft und dann verbrannt. Dabei bilden sich aus der mindestens einen Vorläuferverbindung entsprechende Spezies, die auf dem kornorientierten Elektroband kondensieren können, um auf dem kornorientierten Elektroband eine Isolationsschicht als Film oder aus Partikeln auszubilden. Wird erfindungsgemäß nur eine Vorläuferverbindung eingesetzt, bildet sich auf dem kornorientierten Elektroband eine auf dieser Vorläuferverbindung basierende Isolationsschicht. Werden erfindungsgemäß mehr als eine Vorläuferverbindung eingesetzt, bildet sich auf dem kornorientierten Elektroband eine Isolationsschicht, die Verbindungen enthält, die auf einzelnen Vorläuferverbindungen basieren und/oder auf mehreren Vorläuferverbindungen basieren. Beispiele für Verbindungen, die in der Isolationsschicht enthalten sind, sind beispielsweise ausgewählt aus der Gruppe bestehend aus SiO₂, Al₂O₃, Na₂O, P₂O₅ und Mischungen davon. Erfindungsgemäß hergestellte Isolationsschichten enthalten beispielsweise SiO₂ · Al₂O₃ · P₂O₅, SiO₂, SiO₂ · Na₂O und/oder SiO₂ ▪ Al₂O₃ ▪ P₂O₅ · Na₂O.

In Schritt (B) des erfindungsgemäßen Verfahrens wird die Isolationsschicht in Form eines Films oder von Partikeln ausgebildet. Erfindungsgemäß werden in Schritt (B) Partikel oder ein Film ausgebildet.

Wird das erfindungsgemäß eingesetzte Bottom-Up-Verfahren so betrieben, dass sich die Isolationsschicht aus Partikeln bildet, so weisen die Partikel, die in Schritt (B) des erfindungsgemäßen Verfahrens gebildet werden, bevorzugt einen Durchmesser von 1 bis 30 nm, insbesondere 1 nm bis 25 nm, auf. Diese Partikelgrößen erweisen sich insbesondere bei der Verwendung eines Flammenreaktors als günstig. Der jeweilige Partikeldurchmesser kann erfindungsgemäß mittels dynamischer Lichtstreuung bestimmt werden.

Erfindungsgemäß ist es möglich, dass die Isolationsschicht in Schritt (B) auf einer oder auf beiden Seiten des kornorientierten Stahlbands abgeschieden wird. Beim Abscheiden jeweils einer Isolationsschicht auf beiden Seiten des kornorientierten Elektrobands werden erfindungsgemäß zwei entsprechende Vorrichtungen eingesetzt, jeweils ein Reaktor pro Seite. Alternativ kann das Beschichten der beiden Seiten auch nacheinander erfolgen. In einer bevorzugten Ausführungsform des erfindungsgemäßen Verfahrens liegt die Isolationsschicht auf beiden Seiten des kornorientierten Stahlbandes vor.

Die Temperatur des Abgasstrahls aus dem Flammenreaktor enthaltend die mindestens eine Vorläuferverbindung bzw. die in dem Flammenreaktor daraus entstandenen Spezies beträgt beim Auftreffen auf das kornorientierte Elektroband beispielsweise 200 bis 700 °C.

In Schritt (B) des erfindungsgemäßen Verfahrens kann sich der Ausgang des Flammenreaktors in jeder dem Fachmann als geeignet erscheinenden Entfernung von dem kornorientiertem Elektroband befinden. Bevorzugt befindet sich das kornorientierte Elektroband in Schritt (B) in einem Abstand von 40 mm bis 130 mm, insbesondere 50 mm bis 110 mm ode r t 60 mm bis 90 mm, von dem Ausgang des Flammenreaktors.

Die Ausgestaltung und Funktionsweise eines Mikrowellenplasmareaktors ist dem Fachmann an sich bekannt und beispielsweise beschrieben in der Dissertation von C. Hecht, 2011.

Dabei herrscht in dem Mikrowellenplasmareaktor Atmosphärendruck, beispielsweise 100 bis 1040 mbar (a), bevorzugt 900 bis 1040 mbar (a) oder 980 bis 1040 mbar (a). Die Temperatur im Inneren des Mikrowellenplasmareaktors beträgt beispielsweise 200 bis 700 °C.

Bevorzugt wird in den Mikrowellenplasmareaktor erfindungsgemäß mindestens eine Vorläuferverbindung, die die gewünschte Isolationsschicht ausbilden kann, eingebracht. Erfindungsgemäß bevorzugt können in den Flammenreaktor eine, zwei, drei, vier oder mehr Vorläuferverbindungen eingebracht werden.

Erfindungsgemäß bevorzugt ist die in Schritt (B) eingesetzte mindestens eine Vorläuferverbindung ausgewählt aus oben genannter Gruppe. Bei dem erfindungsgemäßen Einsatz eines Mikrowellenplasmareaktors wird daher bevorzugt mindestens eine Verbindung ausgewählt aus der Gruppe bestehend aus Si-enthaltenden Verbindungen, beispielsweise Tetraethylorthosilicat (C₈H₂₀O₄Si), Hexamethyldisiloxan (C₅H₁₃OSi₂), Trimethylsilanol (C₃H₁₀OSi), Silane wie Monosilan (SiH₄), Disilan (Si₂H₆) usw., Siloxane wie beispielsweise Hexamethylcyclotrisiloxan ("D3" C₆H₁₈O₃S₁₃), Octamethylcyclotetrasiloxan ("D4" C₈H₂₄O₄Si₄) usw. oder Mischungen davon, P-enthaltenden Verbindungen, beispielsweise Tributylphosphat (C₁₂H₂₇O₄P), Tributylphosphin (C₁₂H₂₇P) oder Mischungen davon, Ti-enthaltenden Verbindungen, beispielsweise Tetraisopropyltitanat (C₁₂H₂₈O₄Ti), Titan(IV)-chlorid (TiCl₄), Titanacetylacetonat (C₁₀H₁₆O₅Ti) oder Mischungen davon, Al-enthaltenden Verbindungen, beispielsweise Aluminiumnitrat Al(NO₃)₃ * 9 H₂0, Aluminiumdiacetat (C₄H₇AlO₅), Aluminium(III)-acetylacetonat (C₁₅H₂₁AlO₆) oder Mischungen davon, Erdalkalimetall-enthaltenden Verbindungen, beispielsweise NaOH, NaNOs, NaHCOs, C₂H₃NaO₂, C₅H₇NaO₂ oder Mischungen davon, und Mischungen der genannten Vorläuferverbindungen, eingesetzt.

Bei Verwendung eines Mikrowellenplasmareaktors kann die mindestens eine Vorläuferverbindung bevorzugt gasförmig eingesetzt werden.

Erfindungsgemäß kann die gasförmige Vorläuferverbindung auch in Mischung mit weiteren Gasen eingesetzt werden. Anders als beim Flammenreaktor wird bei einem Mikrowellenplasmareaktor die zur Zerlegung der Precursoren in ihre atomaren Bestandteile benötigte Energie nicht in Form einer Flamme, sondern eines Mikrowellenplasmas eingebracht. Um eine vollständige Umsetzung aller vorhandenen Reaktanten sowie eine vollständige Verbrennung aller Nebenprodukte zu erzielen, werden die Plasmagase, wie Argon, Sauerstoff und Mischungen davon, so eingestellt, dass das lokale Sauerstoff-zu-Kohlenstoff-Verhältnis in der Koagulationszone, welches mittels Laserinduzierter Fluoreszenz-Spektroskopie, kurz LIF (engl. laser-induced fluorescence) gemessen werden kann, einen deutlichen Überschuss an Sauerstoff ergibt, sodass der Kohlenstoff vollständig verbrannt wird und kein Kohlenwasserstoffnetzwerk gebildet werden kann (siehe auch "Laserspektroskopische Charakterisierung von Reaktionsprozessen zur Gasphasensynthese von Nanopartikeln", Diss. C. Hecht, 2011; "Tracer-LIF diagnostics: quantitative measurement of fuel concentration, temperature and fuel/air ratio in practical combustion systems", C. Schulz, V. Sick (Progress in Energy and Combustion Science, Volume 31, Issue 1, 2005, Pages 75-121); "Quantitative measurements of oxygen atom density using LIF", P. Peze, A. Paillous, J. Siffre and B. Dubreuil (Journal of Physics D: Applied Physics, Volume 26, Number 10)).

Erfindungsgemäß bevorzugt wird bei Einsatz eines Mikrowellenplasmareaktors die mindestens eine Vorläuferverbindung gasförmig in Mischung mit mindestens einem Gas, bevorzugt ausgewählt aus der Gruppe bestehend aus Argon, Sauerstoff und Mischungen davon, eingesetzt. Erfindungsgemäß bevorzugt kann der erfindungsgemäßen Gasmischung Wasserstoff, Stickstoff oder Helium zugesetzt werden.

Die Konzentration der mindestens einen Vorläuferverbindung in dem Gasgemisch beträgt dabei bevorzugt mindestens 0,08 vol-%, bevorzugt 0,08 bis 0,50 vol-%.

In dem erfindungsgemäß eingesetzten Flammenreaktor wird die mindestens eine Vorläuferverbindung, bevorzugt in mindestens einem organischen Lösungsmittel gelöst, zunächst verdampft und dann verbrannt.

In dem erfindungsgemäß eingesetzten Mikrowellenplasmareaktor wird die mindestens eine Vorläuferverbindung entweder gasförmig oder mittels eines Bubbiers in die Gasform überführt, in die Reaktionskammer geleitet und mittels Mikrowellenplasma in ihre atomaren Bestandteile zerlegt. Dabei bilden sich aus der mindestens einen Vorläuferverbindung entsprechende Spezies, die auf dem kornorientierten Elektroband kondensieren können, um auf dem kornorientierten Elektroband eine Isolationsschicht als Film auszubilden. Wird erfindungsgemäß nur eine Vorläuferverbindung eingesetzt, bildet sich auf dem kornorientierten Elektroband eine auf dieser Vorläuferverbindung basierende Isolationsschicht. Werden erfindungsgemäß mehr als eine Vorläuferverbindung eingesetzt, bildet sich auf dem kornorientierten Elektroband eine Isolationsschicht, die Verbindungen enthält, die auf einzelnen Vorläuferverbindungen basieren und/oder auf mehreren Vorläuferverbindungen basieren. Beispiele für Verbindungen, die in der Isolationsschicht enthalten sind, sind beispielsweise ausgewählt aus der Gruppe bestehend aus SiO₂, Al₂O₃, Na₂O, P₂O₅ und Mischungen davon. Erfindungsgemäß hergestellte Isolationsschichten enthalten beispielsweise SiO₂, SiO₂ · Al₂O₃ · P₂O₅, SiO₂, SiO₂ ▪ Na₂O und/oder SiO₂ ▪ Al₂O₃ · P₂O₅ ▪ Na₂O.

In Schritt (B) des erfindungsgemäßen Verfahrens wird die Isolationsschicht in Form eines Films oder von Partikeln ausgebildet.

Im Fall der Erzeugung eines Films als Isolierschicht weist dieser Film bei Verwendung eines Mikrowellenplasmareaktors typischerweise eine Dicke von 0,5 µm bis 1,5 µm, insbesondere 0,5 µm bis 0,8 µm, auf. Im Fall, dass die Isolationsschicht aus Partikeln gebildet wird, weisen die Partikel bei der Verwendung eines Mikrowellenplasmareaktors typischerweise einen Durchmesser von 1 nm bis 15 nm, insbesondere von 2 nm bis 12 nm, auf.

Erfindungsgemäß ist es möglich, dass die Isolationsschicht in Schritt (B) auf einer oder auf beiden Seiten des kornorientierten Stahlbands abgeschieden wird. Beim Abscheiden jeweils einer Isolationsschicht auf beiden Seiten des kornorientierten Elektrobands werden erfindungsgemäß zwei Mikrowellenplasmareaktoren eingesetzt, jeweils ein Reaktor pro Seite. Alternativ kann das Beschichten der beiden Seiten auch nacheinander erfolgen. In einer bevorzugten Ausführungsform des erfindungsgemäßen Verfahrens liegt die Isolationsschicht auf beiden Seiten des kornorientierten Stahlbandes vor.

Die Temperatur des Abgasstrahls aus dem Mikrowellenplasmareaktor enthaltend die mindestens eine Vorläuferverbindung bzw. die in dem Flammenreaktor daraus entstandenen Spezies beträgt beim Auftreffen auf das kornorientierte Elektroband beispielsweise 200 bis 700 °C.

In Schritt (B) des erfindungsgemäßen Verfahrens kann sich der Ausgang des Mikrowellenplasmareaktors in jeder dem Fachmann als geeignet erscheinenden Entfernung von dem kornorientiertem Elektroband befinden. Bevorzugt befindet sich das kornorientierte Elektroband in Schritt (B) in einem Abstand von 30 bis 130 mm, bevorzugt 30 bis 70 mm, insbesondere 30 bis 60 mm, von dem Ausgang des Mikrowellenplasmareaktors.

Gemäß einer für die Praxis wichtigen Ausführungsform wird beim erfindungsgemäßen Verfahren nach Schritt (B) mindestens der folgende Schritt (C) zusätzlich durchgeführt: (C) Glühen des mit einer Isolationsschicht auf mindestens einer Seite versehenen kornorientierten Elektrobandes bei einer Temperatur von 650 bis 950 °C.

Der optionale Schritt (C) des erfindungsgemäßen Verfahrens dient dazu, die in Schritt (B) erzeugte Isolationsschicht zu homogenisieren und damit in ihrer Beschaffenheit zu optimieren. Des Weiteren wird durch die Glühung das Metallsubstrat soweit entspannt, dass die magnetischen Kennwerte, insbesondere der Ummagnetisierungsverlust, weiter optimiert sind.

Der optionale Schritt (C) des erfindungsgemäßen Verfahrens erfolgt bei einer Temperatur von 650 bis 950 °C, bevorzugt 800 bis 950 °C, besonders bevorzugt 850 bis 920 °C.

Der optionale Schritt (C) des erfindungsgemäßen Verfahrens erfolgt für einen Zeitraum, der ausreicht, um eine Entspannung des Materials zu gewährleisten. Bevorzugt erfolgt der optionale Schritt (C) für eine Zeit von 10 bis 180 s, bevorzugt 20 bis 150 s, besonders bevorzugt 30 bis 120 s. Die vorliegende Erfindung betrifft auch das mit mindestens einer Isolationsschicht versehene, kornorientierte Elektroband, erhältlich durch das erfindungsgemäße Verfahren. Durch die erfindungsgemäße Verwendung eines Bottom-Up-Verfahrens gelingt es, eine Isolationsschicht bereitzustellen, die besonders gleichmäßig ausgestaltet ist.

Die vorliegende Erfindung betrifft auch ein kornorientiertes Elektroband mit einer Isolationsschicht mit einer Schichtdicke von 0,5 bis 1,5 µm.

Die vorliegende Erfindung betrifft auch ein mit mindestens einer Isolationsschicht versehenes, kornorientiertes Elektroband, wobei es eine Isolation von 180 bis 330 Ω*cm², besonders bevorzugt 190 bis 330 Q*cm², jeweils gemessen nach IEC 60404-11, aufweist.

Weiter weist das erfindungsgemäße mit einer Isolationsschicht versehene, kornorientierte Elektroband einen Glanzwert-Index von 20 bis 70, bevorzugt 20 bis 60, jeweils gemessen mit dem Glossmeter Novo-Gloss Lite 45° des Herstellers Rhopoint Instruments.

Weiter weist das erfindungsgemäße mit einer Isolationsschicht versehene, kornorientierte Elektroband eine übertragene Zugspannung der äußeren Schicht von mindestens 6,0, bevorzugt mindestens 8,0 MPa auf, gemessen wie in EP 2 625 298 beschrieben.

In einer bevorzugten Ausführungsform betrifft die vorliegende Erfindung das erfindungsgemäße kornorientierte Elektroband wobei die Isolationsschicht im Wesentlichen aus SiO₂ besteht. Im Rahmen der vorliegenden Erfindung bedeutet "Im Wesentlichen" einen Anteil von mindestens 99 Gew.-%, bevorzugt mindestens 99,9 Gew.-%.

Weiterhin betrifft die vorliegende Erfindung auch die Verwendung eines erfindungsgemäßen Elektrobandes in Transformatoren, insbesondere im Transformatorkern.

### Beispiele

Die nachfolgenden Ausführungsbeispiele dienen der näheren Erläuterung der Erfindung.

Die in Tabelle 1a und 1b genannten Ausgangsverbindungen werden in dem in den Tabellen 1a und 1b jeweils ebenfalls genannten organischen Lösungsmittel in entsprechender Konzentration gelöst. Die so erhaltene Lösung wird dann mittels einer Spritzenpumpe in einen Sprayflammenreaktor geleitet und dort mit Hilfe einer Spraydüse zerstäubt. Entsprechend den Tabellen 2a, 2b werden die dort genannten Vorläuferverbindungen in einen Mikrowellenplasmareaktor geleitet und dort mit Hilfe eines Bubblers zerstäubt. Der Druck im Sprayflammenreaktor beträgt dabei im Fall der Erzeugung einer als Film ausgebildeten Isolationsschicht 700 mbar und im Fall einer aus Partikeln gebildeten Isolationsschicht 1000 mbar (a). Der Druck im Mikrowellenplasmareaktor ist dagegen gleich dem Atmosphärendruck, d.h. gleich 1000 mbar (a).

Das Verbrennungsluftverhältnis A ist jeweils so eingestellt worden, dass sich eine vollständige Umsetzung aller vorhandenen Reaktanten sowie eine vollständige Verbrennung aller Nebenprodukte eingestellt und kein Kohlenstoff-Wasserstoff-Netzwerk auf der Oberfläche des jeweils zu beschichtenden kornorientierten Elektrobands eingestellt hat.

Die Zündung des Sprays im Flammenreaktor erfolgt dabei über eine Pilotflamme. Während der Verdampfung und Verbrennung des Sprays werden die darin enthaltenen Vorläuferverbindungen bei den dem Fachmann bekannten Flammentemperaturen, siehe dazu Hecht et. al., Appl. Phys. B (2009), 94:119, in ihre atomaren Bestandteile zerlegt und in kondensierbare Spezies überführt. Stromabwärts der Flamme finden dabei die Prozesse statt, die zur Bildung eines Feststoffes auf einem in dem Abstand gemäß Tabelle 1 angebrachten kornorientiertem Elektroband führen. Auf dem kornorientierten Elektroband wird so eine als fester Film ausgebildete Isolationsschicht mit den in den Tabellen 1a - 4a angegebenen Parametern, Dicken und sonstigen Eigenschaften oder eine aus Partikeln gebildete Isolationsschicht mit den in den Tabellen 1b - 4b genannten Parametern, Durchmessern und sonstigen Eigenschaften abgeschieden.

Die Zusammensetzung des jeweils beschichteten kornorientierten Elektrobands war 3,25 Si, 0,039 Cr, 0,07 Cu, 0,116 Sn, 0,06 Mn und 0,014 P, alle Angaben in Gew.-%, Rest Fe und unvermeidbare Verunreinigungen.

Nach Abscheiden des festen Films oder der Partikel wird die erhaltene Schicht bei der in den Tabellen 3a, 3b und 4a, 4b genannten Temperatur für eine Zeit von 120 s eingebrannt und die erhaltenen Elektrobänder hinsichtlich Isolation nach IEC 60404-11, Glanzwert-Index, Schichtdicke und übertragener Zugspannung in der äußeren Schicht, untersucht. Die Messung des Glanzwert-Indexes erfolgt mit dem Glossmeter Novo-Gloss Lite 45° des Herstellers Rhopoint Instruments. Die Messung der Schichtdicke und der übertragenen Zugspannung erfolgt wie in EP 2 625 298 beschrieben.

Bei den mit einem Mikrowellenplasmareaktor durchgeführten Experimenten wurde das lokale Sauerstoff-zu-Kohlenstoff-Verhältnis in der Koagulationszone "Lokales O:C-Verhälnits in der Koagulationszone" so eingestellt, dass ein deutlicher Sauerstoffüberschuss in der Reaktorkammer vorlag. Demzufolge wurde jeglicher Kohlenstoff verbrannt und auch hier die Ausbildung eines Kohlenstoff-Wasserstoff-Netzwerks auf dem jeweils zu beschichtenden kornorientierten Elektroband vermieden.

Die Tabellen 1a, 2a, 3a, 4a, enthalten die Angaben zu Versuchen, bei denen jeweils eine als Film ausgebildete Isolationsschicht erzeugt worden ist, wobei bei den Versuchen gemäß Tabelle 1a, 2a ein Sprayflammenreaktor und bei den Versuchen gemäß den Tabellen 3a, 4a ein Mikrowellenplasmareaktor zum Einsatz gekommen ist.

Die Tabellen 1b, 2b, 3b, 4b enthalten die Angaben zu Versuchen, bei denen jeweils eine aus Partikeln gebildete Isolationsschicht erzeugt worden ist, wobei bei den Versuchen gemäß Tabelle 1b, 2b ein Sprayflammenreaktor und bei den Versuchen gemäß den Tabellen 3b, 4b ein Mikrowellenplasmareaktor zum Einsatz gekommen ist.

Die Erfindung betrifft somit ein Verfahren zur Herstellung eines mit einer Isolationsschicht versehenen kornorientierten Elektrobandes, bei dem ein kornorientiertes Elektroband bereitgestellt und auf mindestens eine Seite des kornorientierten Elektrobandes eine Isolationsschicht aufgebracht wird. Um einerseits das Erzeugen der Isolationsschicht produktionstechnisch zu vereinfachen und andererseits eine optimale Beschaffenheit der Isolationsschicht zu erzielen, schlägt die Erfindung vor, die Isolationsschicht in Form eines Filmes oder in Form von Partikeln auf dem kornorientierten Elektroband durch ein Bottom-Up-Verfahren vorzunehmen, bei dem mindestens eine Vorläuferverbindung aus dem Abgas eines Flammenreaktors oder eines Mikrowellenplasmareaktors auf das kornorientierte Elektroband derart aufgebracht wird, dass die Ausbildung eines Kohlenwasserstoffnetzwerkes auf dem kornorientierten Elektroband vermieden wird.

Durch das erfindungsgemäße Verfahren lässt sich ein kornorientiertes Elektroband erhalten, welches eine Isolationsschicht mit einer hohen Isolation und einem hohen Glanzwert auf mindestens einer Seite aufweist, wobei die Entstehung eines Kohlenstoff-Wasserstoff-Netzwerks auf dem kornorientierten Elektroband vermieden wird und auf diese Weise eine optimal dichte und hinsichtlich ihrer Isolationswirkung optimal effektive Isolationsschicht gewährleistet ist. Dabei kann die erfindungsgemäß erzeugte Isolationsschicht eine hohe Zugspannung auf das Elektroband übertragen. Daher eignet sich ein erfindungsgemäßes kornorientiertes Elektroband im besonderen Maße zur Verwendung in Transformatoren, insbesondere im Transformatorkern.

| **Tabelle 1a: Verwendung eines Sprayflammenreaktors zur Erzeugung einer als Film ausgebildeten Isolationsschicht, eingesetzte Vorläuferverbindungen und weitere Verfahrensparameter** | | | | | | | | | |
|---|---|---|---|---|---|---|---|---|---|
| **Nr.** | **Vorläuferverbindung** | | | | **Lösungsmittel** | **Konzentration** | **A** | **Abstand zur Düse** | **Reaktordruck** |
| | **1*** | **2** | **3**** | **4** | | **[mol/l]** | | **[mm]** | **[mbar (a)]** |
| **1** | TEOS | Al(NO₃)₃ · 9 H₂O | TBP | - | Toluol | 0,3 | 1,10 | 75 | 1000 |
| **2** | TEOS | Al(NO₃)₃ · 9 H₂O | TBP | - | Ethanol | 0,3 | 1,05 | 75 | 1000 |
| **3** | TEOS | Al(NO₃)₃ . 9 H₂O | TBP | - | Toluol/Ethanol* | 0,3 | 1,05 | 75 | 700 |
| **4** | TEOS | - | - | - | Toluol | 0,5 | 1,10 | 75 | 700 |
| **5** | TEOS | NaOH | - | - | Toluol | 0,25 | 1,10 | 75 | 700 |
| **6** | TEOS | NaOH | - | - | Toluol/Ethanol* | 0,25 | 1,05 | 75 | 700 |
| **7** | TEOS | NaNO₃ | - | - | Toluol | 0,25 | 1,10 | 75 | 1000 |
| **8** | TEOS | NaHCO₃ | - | - | Toluol | 0,25 | 1,10 | 75 | 1000 |
| **9** | TEOS | Al(NO₃)₃ · 9 H₂O | TBP | Natriumacetylacetonat | Toluol/Ethanol* | 0,3 | 1,05 | 75 | 700 |
| **10** | HMDSO | Al(NO₃)₃ · 9 H₂O | TBP | - | Toluol | 0,3 | 1,10 | 75 | 700 |
| **11** | HMDSO | Al(NO₃)₃ . 9 H₂O | TBP | - | Ethanol | 0,3 | 1,05 | 75 | 700 |
| **12** | HMDSO | Al(NO₃)₃ . 9 H₂O | TBP | - | Toluol/Ethanol* | 0,3 | 1,05 | 75 | 700 |
| **13** | HMDSO | - | - | - | Toluol | 0,5 | 1,10 | 75 | 700 |
| **14** | HMDSO | NaOH | - | - | Toluol | 0,25 | 1,10 | 75 | 700 |
| **15** | HMDSO | NaOH | - | - | Toluol/Ethanol* | 0,25 | 1,00 | 75 | 700 |
| **16** | HMDSO | NaNO₃ | - | - | Toluol | 0,25 | 1,05 | 75 | 700 |
| **17** | HMDSO | NaHCO₃ | - | - | Toluol | 0,25 | 1,10 | 75 | 700 |
| **18** | HMDSO | Al(NO₃)₃ · 9 H₂O | TBP | Natriumacetylacetonat | Toluol/Ethanol* | 0,3 | 1,05 | 75 | 700 |
| **19** | HMDSO | TTIP | - | - | Ethanol | 0,125 | 1,05 | 75 | 700 |
| **20** | TEOS | Al(NO₃)₃ · 9 H₂O | TBP | - | Toluol | 0,3 | 1,10 | 75 | 700 |
| **21** | TEOS | Al(NO₃)₃ . 9 H₂O | TBP | - | Ethanol | 0,3 | 1,05 | 75 | 700 |
| **22** | TEOS | Al(NO₃)₃ · 9 H₂O | TBP | - | Toluol/Ethanol* | 0,3 | 1,05 | 75 | 700 |
| **23** | HMDSO | Al(NO₃)₃ · 9 H₂O | TBP | - | Toluol | 0,3 | 1,10 | 75 | 1000 |
| **24** | HMDSO | Al(NO₃)₃ · 9 H₂O | TBP | - | Ethanol | 0,3 | 1,05 | 75 | 1000 |
| **25** | HMDSO | Al(NO₃)₃ · 9 H₂O | TBP | - | Toluol/Ethanol* | 0,3 | 1,05 | 75 | 1000 |
| **26** | HMDSO | - | - | - | Toluol | 0,25 | 1,1 | 75 | 700 |

| | | | | | | | | | |
|---|---|---|---|---|---|---|---|---|---|
| * TEOS: Tetraethylorthosilicat (C₈H₂₀O₄Si); HMDSO: Hexamethyldisiloxan (C₆H₁₈OSi₂) ** TBP: Tributylphosphat (C₁₂H₂₇O₄P); TTIP: Tetraisopropyltitanat (C₁₂H₂₈O₄Ti) *** 1:1-Mischung (v/v) | | | | | | | | | |

| **Tabelle 2a: Einbrenntemperatur im Glühschritt C), Ergebnisse** | | | | | | |
|---|---|---|---|---|---|---|
| **Nr. *** | **Einbrenntemperatur** | **Probenuntergrund Forsterit** | **Isolation nach IEC 60404-11** | **Glanzwert** | **Schichtdicke** | **Übertragene Zugspannung der äußeren Schicht** |
| | **[°C]** | | **[Ωcm²]** | | **[µm]** | **[MPa]** |
| **1.1** | 870 | kompakt | 251 | 37 | 1,0 | 7,5 |
| **1.2** | 870 | Poren | 217 | 24 | 1,1 | 7,3 |
| **1.3** | 900 | kompakt | 247 | 37 | 0,9 | 7,4 |
| **V1.4** | 600 | kompakt | 41 | 11 | 1,1 | 2,5 |
| **2.1** | 870 | kompakt | 241 | 32 | 0,9 | 7,0 |
| **2.2** | 870 | Poren | 192 | 20 | 0,9 | 6,6 |
| **2.3** | 900 | kompakt | 261 | 40 | 0,9 | 7,4 |
| **V2.4** | 600 | kompakt | 42 | 16 | 0,8 | 2,7 |
| **3.1** | 870 | kompakt | 284 | 48 | 1,0 | 7,0 |
| **3.2** | 870 | Poren | 268 | 53 | 1,1 | 7,5 |
| **3.3** | 900 | kompakt | 277 | 47 | 0,9 | 7,3 |
| **V3.4** | 600 | kompakt | 52 | 17 | 1,0 | 3,1 |
| **V4.1** | 870 | kompakt | 152 | 24 | 0,9 | 4,5 |
| **4.2** | 870 | Poren | 173 | 21 | 1,0 | 4,4 |
| **4.3** | 900 | kompakt | 274 | 42 | 1,0 | 7,4 |
| **V4.4** | 600 | kompakt | 65 | 33 | 1,0 | 3,5 |
| **5.1** | 870 | kompakt | 261 | 40 | 1,0 | 7,7 |
| **5.2** | 870 | Poren | 250 | 41 | 1,0 | 7,5 |
| **5.3** | 900 | kompakt | 271 | 46 | 0,9 | 7,3 |
| **V5.4** | 600 | kompakt | 74 | 31 | 1,0 | 3,2 |
| **6.1** | 870 | kompakt | 284 | 47 | 0,8 | 7,8 |
| **6.2** | 870 | Poren | 274 | 26 | 0,9 | 7,6 |
| **6.3** | 900 | kompakt | 260 | 47 | 1,1 | 7,5 |
| **V6.4** | 600 | kompakt | 80 | 24 | 0,9 | 3,3 |
| **7.1** | 870 | kompakt | 271 | 48 | 1,0 | 8,0 |
| **7.2** | 870 | Poren | 232 | 48 | 1,2 | 8,0 |
| **7.3** | 900 | kompakt | 250 | 45 | 1,1 | 9,1 |
| **V7.4** | 600 | kompakt | 98 | 28 | 1,0 | 3,3 |
| **8.1** | 870 | kompakt | 251 | 45 | 0,9 | 7,8 |
| **8.2** | 870 | Poren | 257 | 40 | 1,0 | 7,3 |
| **8.3** | 900 | kompakt | 227 | 43 | 1,0 | 7,8 |
| **V8.4** | 600 | kompakt | 48 | 27 | 0,9 | 2,8 |
| **9.1** | 870 | kompakt | 230 | 35 | 1,0 | 8,2 |
| **9.2** | 870 | Poren | 226 | 41 | 1,0 | 7,4 |
| **9.3** | 900 | kompakt | 234 | 41 | 1,0 | 7,5 |
| **V9.4** | 600 | kompakt | 61 | 24 | 0,9 | 3,4 |
| **10.1** | 870 | kompakt | 239 | 36 | 0,9 | 8,0 |
| **10.2** | 870 | Poren | 206 | 28 | 0,9 | 7,6 |
| **10.3** | 900 | kompakt | 249 | 31 | 1,1 | 7,8 |
| **V10.4** | 600 | kompakt | 42 | 20 | 1,0 | 2,7, |
| **11.1** | 870 | kompakt | 242 | 42 | 1,0 | 7,2 |
| **11.2** | 870 | Poren | 203 | 27 | 1,0 | 7,2 |
| **11.3** | 900 | kompakt | 252 | 38 | 0,9 | 7,4 |
| **V11.4** | 600 | kompakt | 67 | 15 | 1,0 | 3,0 |
| **12.1** | 870 | kompakt | 286 | 42 | 1,0 | 7,3 |
| **12.2** | 870 | Poren | 271 | 48 | 0,8 | 7,7 |
| **12.3** | 900 | kompakt | 284 | 50 | 1,0 | 7,3 |
| **V12.4** | 600 | kompakt | 80 | 28 | 1,1 | 3,4 |
| **V13.1** | 870 | kompakt | 141 | 27 | 1,0 | 5,1 |
| **V13.2** | 870 | Poren | 169 | 23 | 1,0 | 4,5 |
| **13.3** | 900 | kompakt | 173 | 39 | 1,0 | 4,4 |
| **V13.4** | 600 | kompakt | 61 | 21 | 1,0 | 3,5 |
| **14.1** | 870 | kompakt | 267 | 40 | 0,8 | 7,4 |
| **14.2** | 870 | Poren | 249 | 41 | 1,1 | 7,5 |
| **14.3** | 900 | kompakt | 247 | 41 | 1,0 | 7,7 |
| **V14.4** | 600 | kompakt | 109 | 20 | 1,1 | 3,1 |
| **15.1** | 870 | kompakt | 302 | 48 | 1,0 | 7,6 |
| **15.2** | 870 | Poren | 281 | 53 | 0,8 | 7,7 |
| **15.3** | 900 | kompakt | 241 | 32 | 0,9 | 8,0 |
| **V15.4** | 600 | kompakt | 97 | 30 | 0,9 | 2,7 |
| **16.1** | 870 | kompakt | 217 | 55 | 1,0 | 8,2 |
| **16.2** | 870 | Poren | 216 | 48 | 1,1 | 7,9 |
| **16.3** | 900 | kompakt | 278 | 50 | 1,0 | 8,1 |
| **V16.4** | 600 | kompakt | 47 | 24 | 1,1 | 3,4 |
| **17.1** | 870 | kompakt | 254 | 38 | 1,0 | 7,7 |
| **17.2** | 870 | Poren | 254 | 37 | 0,9 | 7,6 |
| **17.3** | 900 | kompakt | 242 | 43 | 1,0 | 7,6 |
| **V17.4** | 600 | kompakt | 41 | 25 | 0,9 | 2,7 |
| **18.1** | 870 | kompakt | 211 | 37 | 0,8 | 7,4 |
| **18.2** | 870 | Poren | 228 | 38 | 1,0 | 7,6 |
| **18.3** | 900 | kompakt | 251 | 41 | 0,8 | 7,8 |
| **V18.4** | 600 | kompakt | 48 | 27 | 1,0 | 3,2 |
| **19.1** | 870 | kompakt | 272 | 25 | 0,9 | 8,2 |
| **19.2** | 870 | Poren | 284 | 28 | 1,0 | 7,7 |
| **19.3** | 900 | kompakt | 284 | 22 | 0,9 | 8,1 |
| **V19.4** | 600 | kompakt | 123 | 26 | 0,9 | 3,5 |
| **20.1** | 870 | kompakt | 51 | 31 | 1,2 | 7,2 |
| **20.2** | 870 | Poren | 38 | 27 | 1,1 | 6,9 |
| **20.3** | 900 | kompakt | 36 | 22 | 1,0 | 7,8 |
| **V20.4** | 600 | kompakt | 20 | 9 | 1,1 | 1,6 |
| **21.1** | 870 | kompakt | 60 | 21 | 1,7 | 7,9 |
| **21.2** | 870 | Poren | 28 | 21 | 1,3 | 8,1 |
| **21.3** | 900 | kompakt | 31 | 23 | 1,1 | 7,7 |
| **V21.4** | 600 | kompakt | 48 | 28 | 1,1 | 1,4 |
| **22.1** | 870 | kompakt | 34 | 27 | 1,2 | 8,1 |
| **22.2** | 870 | Poren | 28 | 31 | 1,0 | 7,8 |
| **22.3** | 900 | kompakt | 41 | 20 | 1,7 | 6,9 |
| **V22.4** | 600 | kompakt | 21 | 19 | 1,1 | 1,8 |
| **23.1** | 870 | kompakt | 50 | 27 | 1,1 | 6,7 |
| **23.2** | 870 | Poren | 38 | 24 | 1,0 | 7,7 |
| **23.3** | 900 | kompakt | 45 | 28 | 0,9 | 6,6 |
| **V23.4** | 600 | kompakt | 38 | 23 | 1,0 | 1,9 |
| **24.1** | 870 | kompakt | 62 | 25 | 1,1 | 6,8 |
| **24.2** | 870 | Poren | 25 | 30 | 1,2 | 7,2 |
| **24.3** | 900 | kompakt | 27 | 21 | 1,0 | 7,0 |
| **V24.4** | 600 | kompakt | 40 | 24 | 0,9 | 1,9 |
| **25.1** | 870 | kompakt | 28 | 22 | 1,0 | 7,2 |
| **25.2** | 870 | Poren | 108 | 23 | 1,1 | 6,7 |
| **25.3** | 900 | kompakt | 40 | 26 | 1,1 | 7,8 |
| **V25.4** | 600 | kompakt | 109 | 23 | 0,9 | 1,8 |
| **26.1** | 870 | kompakt | 202 | 20 | 1,0 | 7,7 |
| **26.2** | 870 | Poren | 207 | 41 | 1,0 | 8,0 |
| **26.3** | 900 | kompakt | 212 | 40 | 1,0 | 8,1 |
| **V26.4** | 600 | kompakt | 207 | 31 | 1,1 | 3,5 |

| | | | | | | |
|---|---|---|---|---|---|---|
| * "V..." = Vergleichsversuch | | | | | | |

| **Tabelle 3a: Verwendung eines Mikrowellenplasmareaktors zur Erzeugung einer als Film ausgebildeten Isolationsschicht, eingesetzte Vorläuferverbindungen und weitere Verfahrensparameter** | | | | | | | |
|---|---|---|---|---|---|---|---|
| **Nr.*** | **Plasmagase** | **Mikrowellenleistung** | **Vorläuferverbindung **** | **Konzentration Vorläuferverbindung** | **Druck im Reaktor** | **Abstand zur Düse** | **Lokales O:C-Verhälnits in der Koagulationszone mittels LIF** |
| | | **[W]** | | **[Vol.-%]** | **[mbar (a)]** | **[mm]** | |
| **27** | Argon, Sauerstoff | 800 | HMDSO | 0,10 | 1000 | 40 | 749 |
| **V28** | Argon, Sauerstoff | 800 | HMDSO | 0,075 | 1000 | 40 | 1009 |
| **29** | Argon/Wasserstoff 2:1 (v/v), Sauerstoff | 800 | HMDSO | 0,075 | 1000 | 40 | 864 |
| **30** | Argon, Sauerstoff | 800 | Monosilan SiH₄ | 0,10 | 1000 | 30 | 829 |
| **V31** | Argon, Sauerstoff | 800 | Monosilan SiH₄ | 0,075 | 1000 | 25 | 991 |
| **V32** | Argon/Wasserstoff 2:1 (v/v), Sauerstoff | 800 | Monosilan SiH₄ | 0,075 | 1000 | 25 | 903 |

| | | | | | | | |
|---|---|---|---|---|---|---|---|
| * "V..." = Vergleichsversuch ** "HMDSO" : Hexamethyldisiloxan (C₆H₁₈OSi₂) | | | | | | | |

| **Tabelle 4a: Einbrenntemperatur im Glühschritt, Ergebnisse** | | | | | | |
|---|---|---|---|---|---|---|
| **Nr.*** | **Einbrenntemperatur** | **Probenuntergrund Forsterit** | **Isolation nach IEC 60404-11** | **Glanzwert** | **Schichtdicke** | **Übertragene Zugspannung der äußeren Schicht** |
| | **[°C]** | | **[Ωcm²]** | | **[µm]** | **[MPa]** |
| **27.1** | 870 | Poren | 277 | 38 | 0,9 | 8,2 |
| **27.2** | 870 | kompakt | 236 | 29 | 0,9 | 8,0 |
| **27.3** | 900 | kompakt | 279 | 42 | 0,8 | 8,1 |
| **V27.4** | 600 | kompakt | 45 | 32 | 1,0 | 3,2 |
| **V28.1** | 870 | Poren | 63 | 31 | 0,8 | 3,1 |
| **V28.2** | 870 | Poren | 57 | 28 | 0,9 | 2,9 |
| **V28.3** | 900 | kompakt | 69 | 37 | 0,7 | 3,3 |
| **V28.4** | 600 | kompakt | 45 | 13 | 0,8 | 3,2 |
| **29.1** | 870 | kompakt | 305 | 49 | 1,1 | 8,1 |
| **29.2** | 870 | Poren | 299 | 59 | 0,8 | 8,2 |
| **29.3** | 900 | kompakt | 313 | 38 | 0,9 | 8,4 |
| **V29.4** | 600 | kompakt | 49 | 17 | 0,9 | 3,0 |
| **30.1** | 870 | kompakt | 257 | 31 | 0,9 | 7,8 |
| **30.2** | 870 | Poren | 210 | 27 | 0,9 | 8,1 |
| **30.3** | 900 | kompakt | 290 | 39 | 0,8 | 8,0 |
| **V30.4** | 600 | kompakt | 54 | 19 | 1,0 | 3,9 |
| **V31.1** | 870 | kompakt | 80 | 44 | 0,9 | 2,5 |
| **V31.2** | 870 | Poren | 81 | 52 | 0,8 | 2,3 |
| **V31.3** | 900 | kompakt | 79 | 39 | 0,9 | 2,3 |
| **V31.4** | 600 | kompakt | 73 | 28 | 1,0 | 3,5 |
| **V32.1** | 870 | Poren | 69 | 47 | 0,8 | 1,7 |
| **V32.2** | 870 | Poren | 67 | 50 | 0,9 | 2,4 |
| **V32.3** | 900 | kompakt | 49 | 46 | 0,9 | 2,5 |
| **V32.4** | 600 | kompakt | 87 | 26 | 0,8 | 3,2 |

| | | | | | | |
|---|---|---|---|---|---|---|
| * "V..." = Vergleichsversuch | | | | | | |

| **Tabelle 1b: Verwendung eines Sprayflammenreaktors zur Erzeugung einer aus Partikeln gebildeten Isolationsschicht, eingesetzte Vorläuferverbindungen und weitere Verfahrensparameter** | | | | | | | | | |
|---|---|---|---|---|---|---|---|---|---|
| **Nr.** | **Vorläuferverbindung** | | | | **Lösungsmittel** | **Konzentration** | **A** | **Abstand zur Düse****** | **Reaktordruck** |
| | **1*** | **2** | **3**** | **4** | | **[mol/l]** | | **[mm]** | **[mbar (a)]** |
| **1** | TEOS | Al(NO₃)₃ · 9 H₂O | TBP | - | Toluol | 0,3 | 1,10 | 75 / 105 | 10 |
| **2** | TEOS | Al(NO₃)₃ · 9 H₂O | TBP | - | Ethanol | 0,3 | 1,05 | 75 / 105 | 11 |
| **3** | TEOS | Al(NO₃)₃ . 9 H₂O | TBP | - | Toluol/Ethanol* | 0,3 | 1,10 | 75 / 105 | 7 |
| **4** | TEOS | - | - | - | Toluol | 0,5 | 1,10 | 75 | 4 |
| **5** | TEOS | NaOH | - | - | Toluol | 0,25 | 1,10 | 75 | 4 |
| **6** | TEOS | NaOH | - | - | Toluol/Ethanol* | 0,25 | 1,05 | 75 | 6 |
| **7** | TEOS | NaNOs | - | - | Toluol | 0,25 | 1,10 | 75 | 4 |
| **8** | TEOS | NaHCO₃ | - | - | Toluol | 0,25 | 1,10 | 75 | 7 |
| **9** | TEOS | Al(NO₃)₃ · 9 H₂O | TBP | Natriumacetylacetonat | Toluol/Ethanol* | 0,3 | 1,05 | 75 | 11 |
| **10** | HMDSO | Al(NO₃)₃ · 9 H₂O | TBP | - | Toluol | 0,3 | 1,10 | 75 / 105 | 12 |
| **11** | HMDSO | Al(NO₃)₃ · 9 H₂O | TBP | - | Ethanol | 0,3 | 1,05 | 75 / 105 | 12 |
| **12** | HMDSO | Al(NO₃)₃ . 9 H₂O | TBP | - | Toluol/Ethanol* | 0,3 | 1,10 | 75 / 105 | 8 |
| **13** | HMDSO | - | - | - | Toluol | 0,5 | 1,10 | 75 | 4 |
| **14** | HMDSO | NaOH | - | - | Toluol | 0,25 | 1,10 | 75 | 4 |
| **15** | HMDSO | NaOH | - | - | Toluol/Ethanol* | 0,25 | 1,10 | 75 | 8 |
| **16** | HMDSO | NNaO₃ | - | - | Toluol | 0,25 | 1,10 | 75 | 9 |
| **17** | HMDSO | NaCHO₃ | - | - | Toluol | 0,25 | 1,10 | 75 | 9 |
| **18** | HMDSO | Al(NO₃)₃ · 9 H₂O | TBP | Natriumacetylacetonat | Toluol/Ethanol* | 0,3 | 1,10 | 75 | 10 |
| **19** | HMDSO | TTIP | - | - | | 0,125 | 1,20 | 75 | 4 (SiO₂) und 30 (TiO₂) |
| **20** | TEOS | Al(NO₃)₃ · 9 H₂O | TBP | - | Toluol | 0,3 | 1,10 | 105 / 145 | 21 |
| **21** | TEOS | Al(NO₃)₃ . 9 H₂O | TBP | - | Ethanol | 0,3 | 1,05 | 105 / 145 | 23 |
| **22** | TEOS | Al(NO₃)₃ · 9 H₂O | TBP | - | Toluol/Ethanol* | 0,3 | 1,05 | 105 / 145 | 23 |
| **23** | TEOS | - | - | - | Toluol | 0,5 | 1,10 | 30 | Keine Partikel (CVD) |
| **24** | TEOS | NaOH | - | - | Toluol | 0,25 | 1,10 | 30 | Keine Partikel (CVD) |
| **25** | HMDSO | Al(NO₃)₃ . 9 H₂O | TBP | - | Toluol | 0,3 | 1,10 | 105 / 145 | 31 |
| **26** | HMDSO | Al(NO₃)₃ · 9 H₂O | TBP | - | Ethanol | 0,3 | 1,05 | 105 / 145 | 37 |
| **27** | HMDSO | Al(NO₃)₃ · 9 H₂O | TBP | - | Toluol/Ethanol* | 0,3 | 1,05 | 105 / 145 | 36 |

| **Nr.** | **Vorläuferverbindung** | | | | **Lösungsmittel** | **Konzentration** | **λ** | **Abstand zur Düse****** | **Reaktordruck** |
|---|---|---|---|---|---|---|---|---|---|
| | **1*** | **2** | **3**** | **4** | | **[mol/l]** | | **[mm]** | **[mbar (a)]** |
| **28** | HMDSO | - | - | - | Toluol | 0,25 | 1,10 | 30 | Keine Partikel (CVD) |

| | | | | | | | | | |
|---|---|---|---|---|---|---|---|---|---|
| * TEOS: Tetraethylorthosilicat (C₈H₂₀O₄Si); HMDSO: Hexamethyldisiloxan (C₆H₁₈OSi₂) ** TBP: Tributylphosphat (C₁₂H₂₇O₄P); TTIP: Tetraisopropyltitanat (C₁₂H₂₈O₄Ti) *** 1:1-Mischung (v/v) **** wenn zwei Werte angegeben sind, sind zwei Abstände mit demselben Ergebnis erprobt worden | | | | | | | | | |

| **Tabelle 2b: Einbrenntemperatur im Glühschritt C), Ergebnisse** | | | | | | |
|---|---|---|---|---|---|---|
| **Nr. *** | **Einbrenntemperatur** | **Probenuntergrund Forsterit** | **Isolation nach IEC 60404-11** | **Glanzwert** | **Schichtdicke** | **Übertragene Zugspannung der äußeren Schicht** |
| | **[°C]** | | **[Ωcm²]** | | **[µm]** | **[MPa]** |
| **1.1** | 870 | kompakt | 277 | 40 | 1,0 | 8,4 |
| **1.2** | 870 | Poren | 236 | 33 | 0,8 | 8,1 |
| **1.3** | 900 | kompakt | 279 | 39 | 0,8 | 8,3 |
| **V1.4** | 600 | kompakt | 45 | 5 | 0,9 | 2,9 |
| **2.1** | 870 | kompakt | 257 | 40 | 0,9 | 8,0 |
| **2.2** | 870 | Poren | 210 | 22 | 0,8 | 8,5 |
| **2.3** | 900 | kompakt | 290 | 44 | 0,9 | 8,3 |
| **V2.4** | 600 | kompakt | 45 | 7 | 0,9 | 3,4 |
| **3.1** | 870 | kompakt | 305 | 57 | 0,9 | 8,0 |
| **3.2** | 870 | Poren | 299 | 55 | 0,8 | 8,5 |
| **3.3** | 900 | kompakt | 313 | 52 | 0,9 | 8,3 |
| **V3.4** | 600 | kompakt | 58 | 12 | 1,0 | 3,4 |
| **V4.1** | 870 | kompakt | 178 | 27 | 0,9 | 5,0 |
| **V4.2** | 870 | Poren | 192 | 24 | 0,9 | 4,9 |
| **4.3** | 900 | kompakt | 302 | 51 | 0,9 | 8,3 |
| **V4.4** | 600 | kompakt | 67 | 12 | 1,0 | 3,9 |
| **5.1** | 870 | kompakt | 298 | 47 | 0,9 | 8,5 |
| **5.2** | 870 | Poren | 274 | 45 | 0,9 | 8,3 |
| **5.3** | 900 | kompakt | 300 | 47 | 0,9 | 8,3 |
| **V5.4** | 600 | kompakt | 87 | 20 | 1,0 | 3,5 |
| **6.1** | 870 | kompakt | 311 | 50 | 0,9 | 8,7 |
| **6.2** | 870 | Poren | 304 | 48 | 0,9 | 8,4 |
| **6.3** | 900 | kompakt | 279 | 52 | 0,9 | 8,5 |
| **V6.4** | 600 | kompakt | 87 | 29 | 0,9 | 3,7 |
| **7.1** | 870 | kompakt | 299 | 55 | 1,0 | 8,9 |
| **7.2** | 870 | Poren | 248 | 50 | 0,9 | 8,8 |
| **7.3** | 900 | kompakt | 277 | 52 | 1,0 | 9,0 |
| **V7.4** | 600 | kompakt | 77 | 31 | 0,9 | 3,3 |
| **8.1** | 870 | kompakt | 285 | 49 | 0,9 | 8,7 |
| **8.2** | 870 | Poren | 285 | 44 | 0,9 | 8,1 |
| **8.3** | 900 | kompakt | 252 | 46 | 0,9 | 8,3 |
| **V8.4** | 600 | kompakt | 50 | 30 | 0,9 | 3,1 |
| **9.1** | 870 | kompakt | 250 | 40 | 1,0 | 8,2 |
| **V9.2** | 870 | Poren | 244 | 41 | 1,1 | 8,2 |
| **9.3** | 900 | kompakt | 260 | 45 | 0,9 | 8,5 |
| **V9.4** | 600 | kompakt | 67 | 27 | 0,9 | 3,6 |
| **10.1** | 870 | kompakt | 267 | 42 | 1,0 | 8,8 |
| **10.2** | 870 | Poren | 236 | 31 | 0,9 | 8,4 |
| **10.3** | 900 | kompakt | 279 | 39 | 1,0 | 8,8 |
| **V10.4** | 600 | kompakt | 35 | 21 | 0,9 | 3,0 |
| **11.1** | 870 | kompakt | 255 | 38 | 0,9 | 8,0 |
| **11.2** | 870 | Poren | 220 | 29 | 0,9 | 8,0 |
| **11.3** | 900 | kompakt | 274 | 42 | 0,9 | 8,2 |
| **V11.4** | 600 | kompakt | 74 | 12 | 0,9 | 3,3 |
| **12.1** | 870 | kompakt | 315 | 59 | 0,9 | 8,1 |
| **12.2** | 870 | Poren | 292 | 52 | 0,9 | 8,6 |
| **12.3** | 900 | kompakt | 310 | 51 | 0,8 | 8,1 |
| **V12.4** | 600 | kompakt | 64 | 15 | 1,0 | 3,6 |
| **V13.1** | 870 | kompakt | 159 | 33 | 0,9 | 5,5 |
| **V13.2** | 870 | Poren | 192 | 21 | 0,9 | 5,1 |
| **13.3** | 900 | kompakt | 303 | 47 | 0,9 | 8,2 |
| **V13.4** | 600 | kompakt | 69 | 14 | 1,1 | 3,8 |
| **14.1** | 870 | kompakt | 290 | 45 | 0,9 | 8,2 |
| **14.2** | 870 | Poren | 288 | 45 | 0,9 | 8,3 |
| **14.3** | 900 | kompakt | 285 | 46 | 0,9 | 8,3 |
| **V14.4** | 600 | kompakt | 112 | 22 | 1,0 | 3,9 |
| **15.1** | 870 | kompakt | 332 | 53 | 0,9 | 8,5 |
| **15.2** | 870 | Poren | 309 | 51 | 0,9 | 8,6 |
| **15.3** | 900 | kompakt | 270 | 55 | 0,9 | 8,9 |
| **V15.4** | 600 | kompakt | 99 | 37 | 0,7 | 3,0 |
| **16.1** | 870 | kompakt | 254 | 57 | 1,0 | 9,0 |
| **16.2** | 870 | Poren | 248 | 51 | 0,9 | 8,7 |
| **16.3** | 900 | kompakt | 275 | 50 | 1,0 | 8,9 |
| **V16.4** | 600 | kompakt | 50 | 25 | 0,9 | 3,5 |
| **17.1** | 870 | kompakt | 288 | 41 | 0,9 | 8,5 |
| **17.2** | 870 | Poren | 285 | 41 | 0,9 | 8,4 |
| **17.3** | 900 | kompakt | 263 | 46 | 0,9 | 8,6 |
| **V17.4** | 600 | kompakt | 37 | 22 | 0,7 | 2,9 |
| **18.1** | 870 | kompakt | 234 | 39 | 1,0 | 8,3 |
| **18.2** | 870 | Poren | 247 | 41 | 1,0 | 8,5 |
| **18.3** | 900 | kompakt | 270 | 45 | 0,9 | 8,8 |
| **V18.4** | 600 | kompakt | 53 | 29 | 0,9 | 3,5 |
| **19.1** | 870 | kompakt | 306 | 24 | 1,0 | 9,1 |
| **19.2** | 870 | Poren | 317 | 20 | 1,0 | 8,5 |
| **19.3** | 900 | kompakt | 310 | 25 | 1,0 | 8,9 |
| **V19.4** | 600 | kompakt | 144 | 29 | 0,9 | 3,7 |
| **20.1** | 870 | kompakt | 258 | 22 | 1,2 | 8,0 |
| **20.2** | 870 | Poren | 241 | 21 | 1,0 | 6,5 |
| **20.3** | 900 | kompakt | 239 | 32 | 1,1 | 7,5 |
| **V20.4** | 600 | kompakt | 81 | 7 | 1,0 | 1,7 |
| **21.1** | 870 | kompakt | 267 | 37 | 1,2 | 7,3 |
| **21.2** | 870 | Poren | 301 | 21 | 1,3 | 7,5 |
| **21.3** | 900 | kompakt | 305 | 28 | 0,9 | 6,8 |
| **V21.4** | 600 | kompakt | 53 | 6 | 0,9 | 1,5 |
| **22.1** | 870 | kompakt | 281 | 42 | 1,1 | 8,1 |
| **22.2** | 870 | Poren | 209 | 37 | 1,1 | 7,5 |
| **22.3** | 900 | kompakt | 247 | 31 | 1,0 | 6,9 |
| **V22.4** | 600 | kompakt | 14 | 13 | 1,0 | 1,2 |
| **23.1** | 870 | kompakt | 272 | 32 | 0,9 | 7,2 |
| **23.2** | 870 | Poren | 263 | 41 | 0,9 | 7,3 |
| **23.3** | 900 | kompakt | 249 | 50 | 0,9 | 7,2 |
| **V23.4** | 600 | kompakt | 29 | 46 | 0,9 | 3,4 |
| **24.1** | 870 | kompakt | 307 | 39 | 1,0 | 7,7 |
| **24.2** | 870 | Poren | 291 | 41 | 1,0 | 7,9 |
| **24.3** | 900 | kompakt | 310 | 44 | 1,0 | 7,5 |
| **V24.4** | 600 | kompakt | 288 | 46 | 1,0 | 3,6 |
| **25.1** | 870 | kompakt | 255 | 39 | 1,1 | 8,0 |
| **25.2** | 870 | Poren | 241 | 33 | 0,9 | 7,9 |
| **25.3** | 900 | kompakt | 249 | 21 | 1,1 | 7,4 |
| **V25.4** | 600 | kompakt | 42 | 7 | 1,0 | 2,1 |
| **26.1** | 870 | kompakt | 269 | 23 | 1,0 | 7,7 |
| **26.2** | 870 | Poren | 244 | 20 | 0,9 | 6,8 |
| **26.3** | 900 | kompakt | 281 | 25 | 0,9 | 7,1 |
| **V26.4** | 600 | kompakt | 42 | 11 | 0,9 | 2,1 |
| **27.1** | 870 | kompakt | 230 | 50 | 1,0 | 7,2 |
| **27.2** | 870 | Poren | 242 | 34 | 1,1 | 7,2 |
| **27.3** | 900 | kompakt | 244 | 44 | 1,0 | 6,9 |
| **V27.4** | 600 | kompakt | 14 | 13 | 1,0 | 2,0 |
| **28.1** | 870 | kompakt | 228 | 20 | 1,0 | 7,0 |
| **28.2** | 870 | Poren | 292 | 41 | 1,0 | 7,2 |
| **28.3** | 900 | kompakt | 250 | 40 | 1,0 | 7,4 |
| **V28.4** | 600 | kompakt | 265 | 32 | 1,0 | 3,1 |

| **Tabelle 3b: Verwendung eines Mikrowellenplasmareaktors zur Erzeugung einer aus Partikeln gebildeten Isolationsschicht, eingesetzte Vorläuferverbindungen und weitere Verfahrensparameter** | | | | | | | | |
|---|---|---|---|---|---|---|---|---|
| **Nr.*** | **Plasmagas(e)** | **Mikrowellenleistung** | **VorläuferVerbindung**** | **Konzentration Vorläuferverbindungsgas** | **Druck im Reaktor** | **Abstand zur Düse** | **Partikelgröße** | **Lokales O:C-Verhälnits in der Koagulationszone mittels LIF** |
| | | **[W]** | | **[Vol.-%]** | **[mbar (a)]** | **[mm]** | **[nm]** | |
| 29 | Arqon, Sauerstoff | 800 | HMDSO | 0,10 | 1000 | 60 | 11 | 823 |
| V30 | Argon, Sauerstoff | 800 | HMDSO | 0,075 | 1000 | 60 | 8 | 917 |
| 31 | Argon/Wasserstoff 2:1 (v/v), Sauerstoff | 800 | HMDSO | 0,075 | 1000 | 60 | 7 | 927 |
| 32 | Argon, Sauerstoff | 800 | Monosilan SiH₄ | 0,10 | 1000 | 50 | 6 | 1001 |
| V33 | Argon, Sauerstoff | 800 | Monosilan SiH₄ | 0,075 | 1000 | 45 | 4 | 889 |
| V34 | Argon/Wasserstoff 2:1 (v/v), Sauerstoff | 800 | Monosilan SiH₄ | 0,075 | 1000 | 45 | 9 | 956 |

| | | | | | | | | |
|---|---|---|---|---|---|---|---|---|
| * "V..." = Vergleichsversuch ** "HMDSO" : Hexamethyldisiloxan (C₆H₁₈OSi₂) | | | | | | | | |

| **Tabelle 4b: Einbrenntemperatur im Glühschritt, Ergebnisse** | | | | | | |
|---|---|---|---|---|---|---|
| **Nr.*** | **Einbrenntemperatur** | **Probenuntergrund Forsterit** | **Isolation nach IEC 60404-11** | **Glanzwert** | **Schichtdicke** | **Übertragene Zugspannung der äußeren Schicht** |
| | **[°C]** | | **[Ωcm²]** | | **[µm]** | **[MPa]** |
| **29.1** | 870 | kompakt | 284 | 37 | 0,9 | 8,1 MPa |
| **29.2** | 870 | Poren | 242 | 39 | 0,9 | 7,9 MPa |
| **29.3** | 900 | kompakt | 263 | 24 | 0,9 | 8,0 MPa |
| **V29.4** | 600 | kompakt | 52 | 17 | 0,8 | 3,2 MPa |
| **V30.1** | 870 | kompakt | 174 | 32 | 0,8 | 2,9 MPa |
| **V30.2** | 870 | Poren | 164 | 44 | 1,0 | 3,2 MPa |
| **V30.3** | 900 | kompakt | 129 | 20 | 0,9 | 3,7 MPa |
| **V30.4** | 600 | kompakt | 40 | 41 | 0,9 | 3,0 MPa |
| **31.1** | 870 | kompakt | 269 | 19 | 0,9 | 8,4 |
| **31.2** | 870 | Poren | 301 | 32 | 0,9 | 8,3 |
| **31.3** | 900 | kompakt | 287 | 48 | 0,9 | 8,2 |
| **V31.4** | 600 | kompakt | 48 | 37 | 0,9 | 2,7 |
| **32.1** | 870 | kompakt | 249 | 25 | 0,9 | 7,9 |
| **32.2** | 870 | Poren | 219 | 29 | 0,9 | 8,2 |
| **32.3** | 900 | kompakt | 271 | 32 | 1,0 | 8,1 |
| **V32.4** | 600 | kompakt | 54 | 27 | 0,9 | 3,5 |
| **V33.1** | 870 | kompakt | 118 | 49 | 0,9 | 5,0 |
| **V33.2** | 870 | Poren | 74 | 28 | 0,8 | 3,3 |
| **V33.3** | 900 | kompakt | 89 | 34 | 0,9 | 3,8 |
| **V33.4** | 600 | kompakt | 60 | 51 | 0,9 | 3,0 |
| **V34.1** | 870 | kompakt | 112 | 39 | 0,8 | 3,2 |
| **V34.2** | 870 | Poren | 94 | 24 | 0,8 | 3,8 |
| **V34.3** | 900 | kompakt | 91 | 40 | 0,9 | 3,5 |
| **V34.4** | 600 | kompakt | 67 | 31 | 0,9 | 3,7 |

| | | | | | | |
|---|---|---|---|---|---|---|
| * "V..." = Vergleichsversuch | | | | | | |

## Patentansprüche

1. Verfahren zur Herstellung eines mit einer Isolationsschicht versehenen kornorientierten Elektrobandes, umfassend mindestens die folgenden Schritte:
(A) Bereitstellen eines kornorientierten Elektrobandes, das mit einer Forsterit-Schicht belegt ist,
(B) Aufbringen einer Isolationsschicht mindestens auf die auf einer Seite des kornorientierten Elektrobandes vorhandene Forsterit-Schicht,
**dadurch gekennzeichnet, dass** das Aufbringen der Isolationsschicht in Form eines Filmes oder in Form von Partikeln auf dem kornorientierten Elektroband durch ein Bottom-Up-Verfahren erfolgt, indem mindestens eine Vorläuferverbindung aus dem Abgas eines Flammenreaktors oder eines Mikrowellenplasmareaktors auf das kornorientierte Elektroband aufgebracht wird,
- wobei im Fall, dass ein Flammenreaktor eingesetzt wird,
- ein Verbrennungsluftverhältnis λ von ≥ 1 eingestellt wird,
- die Vorläuferverbindung in mindestens einem organischen Lösungsmittel gelöst eingesetzt wird,
und
- der Druck im Flammenreaktor höchstens gleich dem Atmosphärendruck ist,
und
- wobei im Fall, dass ein Mikrowellenplasmareaktor eingesetzt wird,
- im Mikrowellenplasmagenerator Atmosphärendruck herrscht,
- die mindestens eine Vorläuferverbindung gasförmig in Mischung mit mindestens einem Gas eingesetzt wird,
und
- die Plasmagase so eingestellt werden, dass das lokale Sauerstoff-zu-Kohlenstoff-Verhältnis in der Koagulationszone des Mikrowellenplasmagenerators einen so deutlichen Überschuss an Sauerstoff ergibt, dass Kohlenstoff vollständig verbrannt wird,
- so dass die auf dem kornorientierten Elektroband erzeugte Isolierschicht frei von einem Kohlenwasserstoffnetzwerk ist.

2. Verfahren nach Anspruch 1, **dadurch gekennzeichnet, dass** die Isolationsschicht mittels eines Flammenreaktors aufgebracht wird, die Isolationsschicht in Form von Partikeln aufgebracht wird und im Flammenreaktor ein Druck herrscht, der kleiner ist als der Atmosphärendruck.

3. Verfahren nach Anspruch 1, **dadurch gekennzeichnet, dass** die Isolationsschicht mittels eines Flammenreaktors aufgebracht wird, die Isolationsschicht in Form von Partikeln aufgebracht wird und im Flammenreaktor ein Druck herrscht, der gleich dem Atmosphärendruck ist.

4. Verfahren nach einem der voranstehenden Ansprüche, **dadurch gekennzeichnet, dass** nach Schritt (B) mindestens folgender Schritt (C) durchgeführt wird:
(C) Glühen des mit einer Isolationsschicht auf mindestens einer Seite versehenen kornorientierten Elektrobandes bei einer Temperatur von 650 bis 950 °C.

5. Verfahren nach einem der voranstehenden Ansprüche, **dadurch gekennzeichnet, dass** die Isolationsschicht auf eine auf beiden Seiten des kornorientierten Elektrobandes vorhandene Forsterit-Schicht aufgebracht wird.

6. Verfahren nach einem der voranstehenden Ansprüche, **dadurch gekennzeichnet, dass** die in Schritt (B) eingesetzte mindestens eine Vorläuferverbindung ausgewählt ist aus der Gruppe bestehend aus Si-enthaltenden Verbindungen, P-enthaltenden Verbindungen, Ti-enthaltenden Verbindungen, Al-enthaltenden Verbindungen, Erdalkalimetall-enthaltenden Verbindungen und Mischungen der genannten Vorläuferverbindungen.

7. Verfahren nach einem der voranstehenden Ansprüche, **dadurch gekennzeichnet, dass** bei Einsatz eines Flammenreaktors die mindestens eine Vorläuferverbindung in mindestens einem organischen Lösungsmittel ausgewählt aus der Gruppe bestehend aus Alkoholen, aromatischen Kohlenwasserstoffen, Carbonsäuren und Mischungen davon gelöst ist.

8. Verfahren nach einem der Ansprüche 1 bis 6, **dadurch gekennzeichnet, dass** bei Einsatz eines Mikrowellenplasmareaktors die mindestens eine Vorläuferverbindung gasförmig in Mischung mit mindestens einem Gas ausgewählt aus einer Gruppe bestehend aus Argon, Sauerstoff und Mischungen davon eingesetzt wird.

9. Kornorientiertes Elektroband mit einer auf seiner Oberfläche vorhandenen Forsteritschicht und einer auf die Forsteritschicht aufgetragenen Isolationsschicht, die frei von einem Kohlenwasserstoffnetzwerk ist, wobei die Schichtdicke der Isolationsschicht 0,5 - 1,5 µm beträgt und die Isolationsschicht eine Zugspannung von mindestens 6 MPa auf das Grundmaterial des Elektrobands überträgt und die Isolationsschicht zu mindestens 99 Gew.-% aus SiO₂ besteht, und wobei das kornorientierte Elektroband eine nach IEC 60404-11 gemessene Isolation von 180 bis 330 Ω*cm² sowie einen Glanzwert von 20 bis 70, jeweils gemessen mit dem Glossmeter Novo-Gloss Lite 45° des Herstellers Rhopoint Instruments, aufweist.

10. Verwendung eines gemäß Anspruch 9 beschaffenen Elektrobandes in Transformatoren oder Transformatorkernen.

## Claims

1. Method for manufacturing a grain-oriented electrical steel strip provided with an insulating layer, comprising at least the following steps:
(A) providing a grain-oriented electrical steel strip, which has a forsterite layer on the surface,
(B) applying an insulating layer at least on the forsterite layer on one side of the grain-oriented electrical steel strip,
**characterised in that** applying the insulating layer in the form of a film or in the form of particles on the grain-oriented electrical steel strip is carried out by means of a bottom-up method, **in that** at least one precursor from the exhaust gas of a flame reactor or a microwave plasma reactor is applied to the grain-oriented electrical steel strip,
- wherein in the event that a flame reactor is used,
- an air-fuel ratio λ of ≥ 1 is set,
- the precursor is applied dissolved in at least one organic solvent,
and
- the pressure in the flame reactor is at most equal to the atmospheric pressure,
and
- wherein in the event that a microwave plasma reactor is used,
- the pressure in the microwave plasma reactor is atmospheric pressure,
- the at least one precursor is used in gaseous form in a mixture with at least one gas,
and
- the plasma gases are set so that the local oxygen-to-carbon ratio in the coagulation zone of the microwave plasma reactor yields a significant excess of oxygen so that the carbon is completely combusted,
- in such a way that the insulating layer formed on the grain-oriented electrical steel strip is free of a hydrocarbon network.

2. Method according to claim 1, **characterised in that** the insulating layer is applied by means of a flame reactor, the insulating layer is applied in the form of particles and there is a pressure in the flame reactor which is less than the atmospheric pressure.

3. Method according to claim 1, **characterised in that** the insulating layer is applied by means of a flame reactor, the insulating layer is applied in the form of particles and there is a pressure in the flame reactor which is equal to the atmospheric pressure.

4. Method according to any one of the preceding claims, **characterised in that** at least the following step (C) is carried out after step (B):
(C) annealing the grain-oriented electrical steel strip with an insulating layer on at least one side at a temperature of 650 to 950°C.

5. Method according to any one of the preceding claims, **characterised in that** the insulating layer is applied to one of the forsterite layers present on both sides of the grain-oriented electrical steel strip.

6. Method according to any one of the preceding claims, **characterised in that** the at least one precursor used in step (B) is selected from the group consisting of compounds containing Si, compounds containing P, compounds containing Ti, compounds containing Al, compounds containing alkaline earth metals and mixtures of the mentioned precursors.

7. Method according to any one of the preceding claims, **characterised in that**, when a flame reactor is used, the at least one precursor is dissolved in at least one organic solvent, selected from the group consisting of alcohols, aromatic hydrocarbons, carboxylic acids and mixtures thereof.

8. Method according to any one of claims 1 to 6, **characterised in that**, when a microwave plasma reactor is used, the at least one precursor is used in gaseous form in a mixture with at least one gas, selected from a group consisting of argon, oxygen and mixtures thereof.

9. Grain-oriented electrical steel strip which has a forsterite layer on its surface and an insulating layer applied on the forsterite layer, which is free of a hydrocarbon network, wherein the layer thickness of the insulating layers is 0.5 - 1.5 µm and the insulating layer transmits a tensile stress of at least 6 MPa to the base material of the electric strip and the insulating layer consists of at least 99 wt.% SiO₂ and wherein the grain-oriented electrical steel strip has an insulation measured in accordance with IEC 60404-11 of 180 to 330 Ω*cm² and a gloss value of 20 to 70, in each case measured with the glossmeter Novo-Gloss Lite 45° from the manufacturer Rhopoint Instruments.

10. Use of an electrical steel strip according to claim 9 in transformers or transformer cores.

## Revendications

1. Procédé de fabrication d'un feuillard électrique à grains orientés pourvu d'une couche isolante, comprenant au moins les étapes suivantes :
(A) fourniture d'un feuillard électrique à grains orientés, lequel est recouvert d'une couche de forstérite,
(B) application d'une couche isolante au moins sur la couche de forstérite présente sur une face du feuillard électrique à grains orientés,
**caractérisé en ce que** l'application de la couche isolante sur le feuillard électrique à grains orientés sous la forme d'un film ou sous la forme de particules se fait par un procédé ascendant, **en ce qu'**au moins un composé précurseur issu d'un gaz d'échappement d'un réacteur à flamme ou d'un réacteur plasma micro-onde est appliqué sur le feuillard électrique à grains orientés,
- dans lequel, dans le cas où un réacteur à flamme est utilisé,
- un rapport d'air de combustion λ de ≥ 1 est défini,
- le composé précurseur est utilisé dissous dans au moins un solvant organique,
et
- la pression dans le réacteur à flamme est au plus égale à la pression atmosphérique,
et
- dans lequel, dans le cas où un réacteur plasma micro-onde est utilisé,
- il existe une pression atmosphérique dans le générateur plasma micro-onde,
- l'au moins un composé précurseur est utilisé sous forme gazeuse en mélange avec au moins un gaz,
et
- les gaz plasma sont régulés de sorte que le rapport oxygène à carbone local dans la zone de coagulation du générateur plasma micro-onde aboutit à un excédent significatif d'oxygène de manière à ce que le carbone soit complètement brûlé,
- de sorte que la couche isolante formée sur le feuillard électrique à grains orientés est exempte d'un réseau d'hydrocarbures.

2. Procédé selon la revendication 1, **caractérisé en ce que** la couche isolante est appliquée à l'aide d'un réacteur à flamme, la couche isolante est appliquée sous la forme de particules et il règne dans le réacteur à flamme une pression inférieure à la pression atmosphérique.

3. Procédé selon la revendication 1, **caractérisé en ce que** la couche isolante est appliquée à l'aide d'un réacteur à flamme, la couche isolante est appliquée sous la forme de particules et il règne dans le réacteur à flamme une pression égale à la pression atmosphérique.

4. Procédé selon l'une des revendications précédentes, **caractérisé en ce que**, après l'étape (B), au moins l'étape (C) suivante est réalisée :
(C) recuit, à une température de 650 à 950 °C, du feuillard électrique à grains orientés pourvu d'une couche isolante sur au moins une face.

5. Procédé selon l'une des revendications précédentes,
**caractérisé en ce que** la couche isolante est appliquée sur une couche de forstérite présente sur les deux faces du feuillard électrique à grains orientés.

6. Procédé selon l'une des revendications précédentes,
**caractérisé en ce que** l'au moins un composé précurseur utilisé à l'étape (B) est choisi dans le groupe constitué par des composés contenant du Si, composés contenant du P, composés contenant du Ti, composés contenant de l'Al, composés contenant des métaux alcalino-terreux et des mélanges des composés précurseurs mentionnés.

7. Procédé selon l'une des revendications précédentes,
**caractérisé en ce que**, en cas d'utilisation d'un réacteur à flamme, l'au moins un composé précurseur est dissous dans au moins un solvant organique choisi dans le groupe constitué par des alcools, hydrocarbures aromatiques, acides carboxyliques et mélanges de ceux-ci.

8. Procédé selon l'une des revendications 1 à 6, **caractérisé en ce que**, en cas d'utilisation d'un réacteur plasma micro-onde, l'au moins un composé précurseur est utilisé sous forme gazeuse en mélange avec au moins un gaz choisi dans un groupe constitué par l'argon, oxygène et mélanges de ceux-ci.

9. Feuillard électrique à grains orientés, comportant une couche de forstérite présente sur sa surface et une couche isolante appliquée sur la couche de forstérite, laquelle couche isolante est exempte d'un réseau d'hydrocarbures, dans lequel l'épaisseur de couche de la couche isolante est de 0,5 à 1,5 µm, et la couche isolante transmet une tension d'au moins 6 MPa au matériau de base du feuillard électrique, et la couche isolante est constituée d'au moins 99 % en poids de SiO₂, et dans lequel le feuillard électrique à grains orientés présente une isolation de 180 à 330 Ω*cm², mesurée selon la norme IEC 60404-11, ainsi qu'une valeur de brillance de 20 à 70, mesurée respectivement à l'aide du brillancemètre Novo-Gloss Lite 45° du fabricant Rhopoint Instruments.

10. Utilisation d'un feuillard électrique, obtenu selon la revendication 9, dans des transformateurs ou des noyaux de transformateurs.
